(19) Europäisches Patentamt / European Patent Office / Office européen des brevets

(11) EP 4 668 021 A1

(12) **EUROPEAN PATENT APPLICATION**
published in accordance with Art. 153(4) EPC

(43) Date of publication:
**24.12.2025 Bulletin 2025/52**

(21) Application number: **25755283.6**

(22) Date of filing: **17.02.2025**

(51) International Patent Classification (IPC):
***G03F 7/105*** (2006.01) ***C08F 287/00*** (2006.01)
***C08F 2/44*** (2006.01) ***C08F 2/50*** (2006.01)
***C08G 77/42*** (2006.01) ***C08G 77/38*** (2006.01)
***C08G 77/12*** (2006.01) ***C08K 5/3417*** (2006.01)
***C08K 5/55*** (2006.01) ***C08K 5/549*** (2006.01)

(52) Cooperative Patent Classification (CPC):
**C08F 2/44; C08F 2/50; C08F 287/00; C08G 77/12; C08G 77/38; C08G 77/42; C08K 5/3417; C08K 5/41; C08K 5/549; C08K 5/55; G03F 7/105**

(86) International application number:
**PCT/KR2025/002237**

(87) International publication number:
**WO 2025/174140 (21.08.2025 Gazette 2025/34)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **16.02.2024 KR 20240022510**

(71) Applicant: **LG Chem, Ltd.**
**Seoul 07336 (KR)**

(72) Inventors:
- **HONG, Chulsuk**
  **Daejeon 34122 (KR)**
- **LEE, Hanna**
  **Daejeon 34122 (KR)**
- **KIM, Min Soo**
  **Daejeon 34122 (KR)**
- **MOON, Sang Pil**
  **Daejeon 34122 (KR)**
- **YI, Yeonhui**
  **Daejeon 34122 (KR)**
- **JUNG, Soonhwa**
  **Daejeon 34122 (KR)**
- **HEO, Yongjoon**
  **Daejeon 34122 (KR)**

(74) Representative: **Plasseraud IP**
**104 Rue de Richelieu**
**CS92104**
**75080 Paris Cedex 02 (FR)**

(54) **HOLOGRAM RECORDING MEDIUM, METHOD FOR MANUFACTURING SAME, AND OPTICAL ELEMENT COMPRISING SAME**

(57) The present disclosure relates to a hologram recording medium, a preparation method thereof, and an optical element comprising the same. The hologram recording medium is capable of recording full-color optical information, has excellent diffraction efficiency in the red, green, and blue regions, and has excellent stability at room temperature and high temperature, so that it can exhibit excellent reliability even when left at room temperature for a long time or exposed to high temperature.

EP 4 668 021 A1

【FIG. 1】

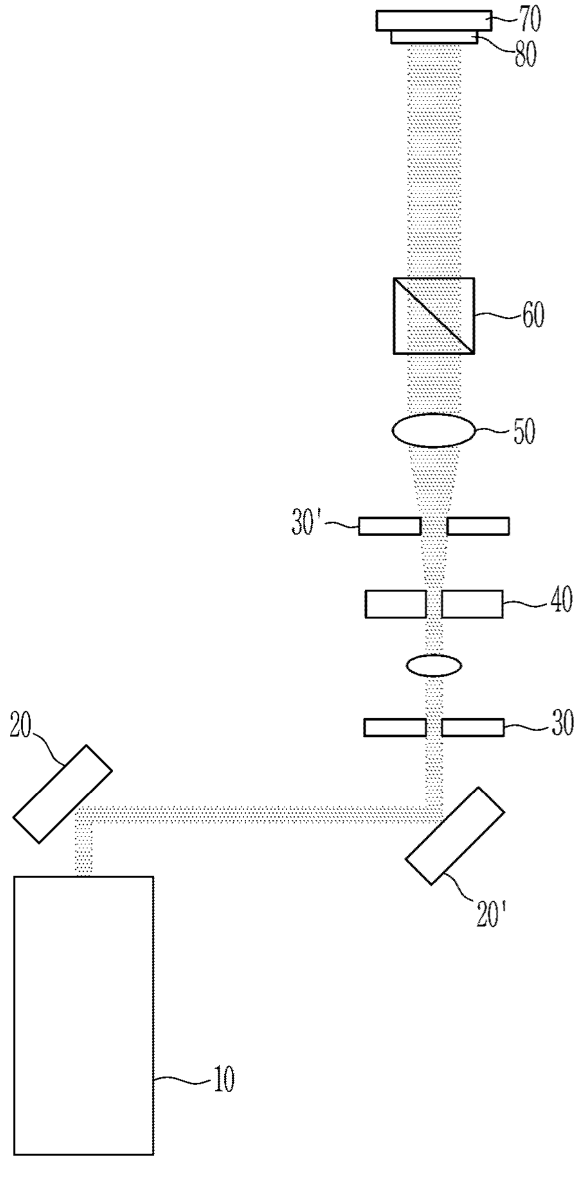

## Description

## [TECHNICAL FIELD]

Cross-reference to Related Application(s)

This application claims the benefit of Korean Patent Application No. 10-2024-0022510 filed on February 16, 2024 with the Korean Intellectual Property Office, the disclosures of which are herein incorporated by reference in their entirety.

The present disclosure relates to a hologram recording medium, a preparation method thereof, and an optical element comprising the same.

## [BACKGROUND OF ART]

Hologram recording medium records information by changing a refractive index in the holographic recording layer in the medium through an exposure process, reads the variation of refractive index in the medium thus recorded, and reproduces the information.

In this regard, a photopolymer composition can be used for preparing a hologram. The photopolymer can easily store light interference pattern as a hologram by photopolymerization of a photoreactive monomer. Therefore, the photopolymer can be used in various fields such as, for example, smart devices such as mobile devices, wearable display parts, vehicle articles (e.g., head up display), holographic fingerprint recognition system, optical lenses, mirrors, deflecting mirrors, filters, diffusing screens, diffraction elements, light guides, waveguides, holographic optical elements having projection screen and/or mask functions, medium of optical memory system and light diffusion plate, optical wavelength multiplexers, reflection type, transmission type color filters, and the like.

Specifically, a photopolymer composition for preparing a hologram includes a polymer matrix, a photoreactive monomer, and a photoinitiator system, and the photopolymer layer prepared from such a composition is irradiated with laser interference light to induce photopolymerization of local monomers.

A refractive index modulation is generated through this local photopolymerization process, and a diffraction grating is generated by such a refractive index modulation. The refractive index modulation value ($\triangle n$) is influenced by the thickness and the diffraction efficiency (DE) of the photopolymer layer, and the angular selectivity increases as the thickness decreases.

Recently, a request for development of materials capable of maintaining a stable hologram with a high diffraction efficiency has been increased, and also various attempts have been made to prepare a hologram recording medium having high diffraction efficiency and high refractive index modulation values as well as a thin thickness.

## [DETAILED DESCRIPTION OF THE INVENTION]

### [Technical Problem]

According to an embodiment of the present disclosure, a hologram recording medium is provided.

According to another embodiment of the present disclosure, a method for preparing the hologram recording medium is provided.

According to yet another embodiment of the present disclosure, an optical element comprising the hologram recording medium is provided.

### [Technical Solution]

Hereinafter, a hologram recording medium, a preparation method thereof, an optical element comprising the same, and the like according to specific embodiments of the present disclosure will be described.

The term "hologram recording medium" as used herein means a medium (or media) on which optical information can be recorded in an entire visible range and an ultraviolet range (e.g., 300 to 1,200 nm) through an exposure process, unless specifically stated otherwise. Therefore, the hologram recording medium herein may mean a medium on which optical information is recorded, or may mean a medium before recording that is capable of recording optical information. The hologram herein may include all of visual holograms such as in-line (Gabor) holograms, off-axis holograms, full-aperture transfer holograms, white light transmission holograms ("rainbow holograms"), Denisyuk holograms, off-axis reflection holograms, edge-literature holograms or holographic stereograms.

In this specification, in relation to environmental conditions, etc. under which a hologram recording medium or a device including the same is placed, "high temperature" may mean a temperature of 60°C or more. For example, the high temperature may mean a temperature of 65°C or more, 70°C or more, 75°C or more, 80°C or more, 85°C or more, 90°C or

more, 95 °C or more, 100°C or more, 105°C or more, 110°C or more, 115°C or more, or 120°C or more, and the upper limit thereof is not particularly limited, but may be, for example, 200°C or less, 150°C or less, 140°C or less, or 130°C or less.

In this specification, when temperature affects the characteristics of a material, object, or component, unless temperature is specifically mentioned otherwise, the temperature condition under which the characteristic is measured or explained may mean a room temperature (e.g., a temperature in the range of about 15 to 30°C which is a temperature without heating or cooling).

In this specification, unless otherwise stated, the measured values such as diffraction efficiency are understood to be those of a photopolymer layer comprised in a hologram recording medium.

According to one embodiment of the disclosure, there is provided a hologram recording medium comprising: a photopolymer layer which includes a polymer matrix or a precursor thereof; and a photoreactive monomer and a photoinitiator system or a photopolymer obtained therefrom; wherein the photoinitiator system includes a photosensitizing dye and a co-initiator, wherein the photosensitizing dye includes a photosensitizing dye for the red region, a photosensitizing dye for the green region, and a photosensitizing dye for the blue region, wherein room temperature DE retention rates of the red region, the green region, and the blue region calculated by the following Equation 1 are 95% or more, and wherein high temperature DE retention rates of the red region, the green region, and the blue region calculated by the following Equation 2 are 86% or more.

[Equation 1]

$$\text{room temperature DE retention rate (\%)} = 100 \times DE^{RT} / DE^{0}$$

[Equation 2]

$$\text{high temperature DE retention rate (\%)} = 100 \times DE^{HT} / DE^{0}$$

in Equations 1 and 2,

> $DE^0$ is a diffraction efficiency of the red region, the green region, or the blue region measured after recording a Notch filter hologram by irradiating light in the red region, the green region, or the blue region onto the hologram recording medium,
> $DE^{RT}$ is a diffraction efficiency of the red region, the green region, or the blue region measured after recording a Notch filter hologram by irradiating light in the red region, the green region, or the blue region onto the hologram recording medium which is stored at 20 to 30°C for 180 days in an unrecorded state, and
> $DE^{HT}$ is a diffraction efficiency of the red region, the green region, or the blue region measured after recording a Notch filter hologram by irradiating light in the red region, the green region, or the blue region onto the hologram recording medium which is stored at 60°C for 30 days in an unrecorded state.

For a hologram recording medium to be utilized in various applications, it must be capable of optical recording in the red region, the green region, and the blue region. However, in conventional hologram recording media capable of optical recording with light in the blue region, the optical recording characteristics have not been satisfactory, especially in terms of poor thermal stability, making them unsuitable for hologram recording media that are easily exposed to high-temperature environments.

The present inventors have completed the present invention by developing a full-color hologram recording medium capable of optical recording in the red region, the green region, and the blue region, which secures both room temperature storage stability and high-temperature stability simultaneously.

A hologram recording medium, a preparation method thereof, an optical element comprising the hologram recording medium, and the like according to one embodiment of the present disclosure will be described below.

The hologram recording medium of one embodiment includes a photopolymer layer which includes a polymer matrix or a precursor thereof; and a photoreactive monomer and a photoinitiator system or a photopolymer obtained therefrom.

The photopolymer layer may be a photopolymer layer in the state before recording that is capable of recording optical information, or may be a photopolymer layer in the state in which optical information is recorded.

A photopolymer layer on which optical information is recorded can be prepared by irradiating an object light and a reference light onto the photopolymer layer before recording. When an object light and a reference light are irradiated onto the photopolymer layer before recording, due to the interference field between the object light and the reference light, the photoinitiator system is present in an inactive state in the destructive interference region, and photopolymerization of the

photoreactive monomer does not occur, and in the constructive interference region, photopolymerization of the photoreactive monomer occurs due to the activated photoinitiator system. As the photoreactive monomer is continuously consumed in the constructive interference region, a concentration difference occurs between the photoreactive monomer in the destructive interference region and the constructive interference region. As a result, the photoreactive monomer in the destructive interference region diffuses into the constructive interference region. Since the photoreactive monomer and the photopolymer formed therefrom have a high refractive index compared to the polymer matrix, a spatial change in the refractive index occurs in the photopolymer layer, and a grating is generated by the spatial refractive index modulation occurring in the photopolymer layer. Such a grating surface plays the role of a reflective surface that reflects incident light due to the difference in refractive index. When light having the wavelength at the time of recording is incident in the direction of the reference light after recording the hologram, it satisfies the Bragg condition and the light diffracts in the direction of the original object light, which makes it reproduce holographic optical information.

Therefore, if the photopolymer layer is in a state before recording, the photopolymer layer may include a photoreactive monomer and a photoinitiator system in a randomly dispersed form within a polymer matrix or its precursor.

On the other hand, if optical information is recorded on the photopolymer layer, the photopolymer layer may include a photopolymer distributed in a polymer matrix to form a grating.

The photopolymer layer is formed from a photopolymer composition which includes a polymer matrix or a precursor thereof, a photoreactive monomer and a photoinitiator system.

The polymer matrix may be, for example, formed by crosslinking a siloxane-based polymer containing a silane functional group (Si-H) and an acrylic-based polyol. Specifically, the polymer matrix may be formed by crosslinking an acrylic-based polyol with a siloxane-based polymer containing a silane functional group. More specifically, the hydroxy group of the acrylic-based polyol can form a crosslink with the silane functional group of the siloxane-based polymer through a hydrosilylation reaction. The hydrosilylation reaction can proceed rapidly under a Pt-based catalyst even at room temperature (e.g., a temperature in the range of about 15 to 30°C which is a temperature without heating or cooling). Therefore, the photopolymer layer employs a polymer matrix that can be quickly crosslinked even at room temperature as a support, thereby being able to improve the preparation efficiency and productivity.

The polymer matrix can enhance the mobility of components (e.g., photoreactive monomer or plasticizer, etc.) contained in the photopolymer layer due to the flexible main chain of the siloxane-based polymer. In addition, siloxane bonding having excellent heat resistance and moist heat resistance properties can facilitate ensuring reliability of the photopolymer layer in which optical information is recorded, and of the hologram recording medium including the same.

The polymer matrix may have a relatively low refractive index, which can serve to enhance the refractive index modulation of the photopolymer layer formed from the photopolymer composition. For example, the upper limit of the refractive index of the polymer matrix may be 1.53 or less, 1.52 or less, 1.51 or less, 1.50 or less, or 1.49 or less. And, the lower limit of the refractive index of the polymer matrix may be, for example, 1.40 or more, 1.41 or more, 1.42 or more, 1.43 or more, 1.44 or more, 1.45 or more, or 1.46 or more. As used herein, "refractive index" may be a value measured with an Abbe refractometer at 25°C.

The photopolymer layer may include the polymer matrix in crosslinked form as described above, or may include a precursor thereof. When the photopolymer layer includes a precursor of the polymer matrix, it may include a siloxane-based polymer, an acrylic-based polyol, and a Pt-based catalyst.

The siloxane-based polymer may include, for example, a repeating unit represented by the following Chemical Formula 1 and a terminal end group represented by the following Chemical Formula 2.

[Chemical Formula 1]

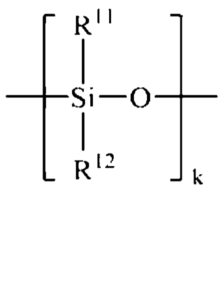

in Chemical Formula 1,

a plurality of $R^{11}$ and $R^{12}$ are the same or different from each other, and are each independently hydrogen, halogen, or an alkyl group having 1 to 10 carbon atoms, and
k is an integer of 1 to 10,000,

[Chemical Formula 2]

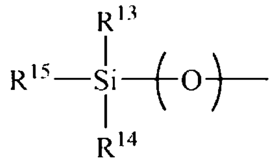

in Chemical Formula 2,
a plurality of $R^{13}$ to $R^{15}$ are the same or different from each other, and are each independently hydrogen, halogen, or an alkyl group having 1 to 10 carbon atoms, and
at least one of $R^{11}$ to $R^{15}$ of at least one repeating unit selected among the repeating units represented by Chemical Formula 1 and any one terminal end group selected among the terminal end groups represented by Chemical Formula 2 is hydrogen.

In Chemical Formula 2, -(O)- means either bonding through oxygen (O) or directly bonding without oxygen (O) when Si of the terminal end group represented by Chemical Formula 2 is bonded to the repeating unit represented by Chemical Formula 1.

As used herein, "alkyl group" may be a straight chain, branched chain, or cyclic alkyl group. By way of non-limiting example, "alkyl group" as used herein may be methyl, ethyl, propyl (e.g. n-propyl, isopropyl, etc.), butyl (e.g., n-butyl, isobutyl, tert-butyl, sec-butyl, cyclobutyl, etc.), pentyl (e.g., n-pentyl, isopentyl, neopentyl, tert-pentyl, 1,1-dimethyl-propyl, 1-ethyl-propyl, 1-methyl-butyl, cyclopentyl, etc.), hexyl (e.g., n-hexyl, 1-methylpentyl, 2-methylpentyl, 4-methylpentyl, 3,3-dimethylbutyl, 1-ethyl-butyl, 2-ethylbutyl, cyclopentylmethyl, cyclohexyl, etc.), heptyl (e.g., n-heptyl, 1-methylhexyl, 4-methylhexyl, 5-methylhexyl, cyclohexylmethyl, etc.), octyl (e.g., n-octyl, tert-octyl, 1-methylheptyl, 2-ethylhexyl, 2-propylpentyl, etc.), nonyl (e.g., n-nonyl, 2,2-dimethylheptyl, etc.), and the like.

In one example, $R^{11}$ to $R^{15}$ in Chemical Formulas 1 and 2 are methyl or hydrogen, and at least two of $R^{11}$ to $R^{15}$ may be hydrogen. More specifically, the siloxane-based polymer may be a compound in which $R^{11}$ and $R^{12}$ of Chemical Formula 1 are each independently methyl and hydrogen, and $R^{13}$ to $R^{15}$ of Chemical Formula 2 are each independently methyl or hydrogen (e.g., polymethylhydrosiloxane whose terminal end group is a trimethylsilyl group or a dimethylhydrosilyl group); a compound in which some $R^{11}$ and $R^{12}$ of Chemical Formula 1 are methyl and hydrogen, respectively, both the remaining $R^{11}$ and $R^{12}$ are methyl, and $R^{13}$ to $R^{15}$ of Chemical Formula 2 are each independently methyl or hydrogen (e.g., poly(dimethylsiloxane-co-methylhydrosiloxane) whose terminal end group is a trimethylsilyl group or a dimethylhydrosilyl group); or a compound in which both $R^{11}$ and $R^{12}$ of Chemical Formula 1 are methyl, at least one of $R^{13}$ to $R^{15}$ of Chemical Formula 2 is hydrogen, and the remainder are each independently methyl or hydrogen (e.g., polydimethylsiloxane in which either or both of the terminal end groups are dimethylhydrosilyl groups).

The siloxane-based polymer may have a number average molecular weight (Mn) in the range of 200 to 4,000 as an example. Specifically, the lower limit of the number average molecular weight of the siloxane-based polymer may be, for example, 200 or more, 250 or more, 300 or more, or 350 or more, and the upper limit thereof may be, for example, 3,500 or less, 3,000 or less, 2,500 or less, 2,000 or less, 1,500 or less, or 1,000 or less. When the number average molecular weight of the siloxane-based polymer satisfies the above range, it is possible to prevent the problems that during the crosslinking process with an acrylic-based polyol which is performed at room temperature or higher, the siloxane-based polymer volatilizes and the degree of matrix crosslinking decreases, or the siloxane-based polymer has poor compatibility with other components of the photopolymer layer and thus, phase separation occurs between the components, thereby allowing the hologram recording medium to exhibit excellent optical recording characteristics and durability under high temperature conditions.

The number average molecular weight means a number average molecular weight (unit: g/mol) in terms of polystyrene determined by GPC method. In the process of determining the number average molecular weight in terms of polystyrene measured by the GPC method, a commonly known analyzing device, a detector such as a refractive index detector, and an analytical column may be used, and commonly applied conditions for temperature, solvent, and flow rate may be used. Specific examples of the measurement conditions may include a temperature of 25°C, tetrahydrofuran solvent and a flow rate of 1 mL/min.

The acrylic-based polyol may mean a polymer in which one or more, specifically two or more, hydroxy groups are bonded to the main chain or side chain of an acrylate-based polymer. Unless specifically stated otherwise, "acrylic-based" as used herein refers to one or more selected from the group consisting of acryloyl group, methacryloyl group and derivatives thereof, or a repeating unit formed by polymerization thereof. Unless specifically stated otherwise, "acrylate-based" as used herein refers to one or more selected from the group consisting of acrylate and methacrylate, or a repeating unit formed by polymerization thereof.

The acrylic-based polyol is a homopolymer of an acrylate-based monomer having a hydroxy group, a copolymer of two or more types of acrylate-based monomers having a hydroxy group, or a copolymer of an acrylate-based monomer having a hydroxy group and an acrylate-based monomer having no hydroxy group. As used herein, "copolymer" is a term that encompasses all of a random copolymer, a block copolymer and a graft copolymer, unless otherwise specified.

The acrylate-based monomer having a hydroxy group may include, for example, hydroxyalkyl (meth)acrylate, hydroxyaryl (meth)acrylate, or the like, the alkyl is an alkyl having 1 to 30 carbon atoms, and the aryl may be an aryl having 6 to 30 carbon atoms. Further, the acrylate-based monomer having no hydroxy group may include, for example, an alkyl (meth)acrylate, an aryl (meth)acrylate, or the like, the alkyl may be an alkyl having 1 to 30 carbon atoms, and the aryl may be an aryl having 6 to 30 carbon atoms. Unless specifically stated otherwise, "(meth)acrylate" as used herein refers to acrylate and/or methacrylate.

The acrylic-based polyol may have a weight average molecular weight (Mw) in the range of 150,000 to 1,000,000 as an example. The weight average molecular weight means a weight average molecular weight in terms of polystyrene measured by the GPC method as described above. For example, the lower limit of the weight average molecular weight may be 150,000 or more, 200,000 or more, or 250,000 or more, and the upper limit thereof may be, for example, 900,000 or less, 850,000 or less, 800,000 or less, 750,000 or less, 700,000 or less, 650,000 or less, 600,000 or less, 550,000 or less, 500,000 or less, or 450,000 or less. When the weight average molecular weight of the acrylic-based polyol satisfies the above range, the polymer matrix sufficiently exerts the function as a support and thus, the recording properties for optical information less decrease even after the usage time has passed, and sufficient flexibility is imparted to the polymer matrix, thereby being able to improve the mobility of components (e.g., photoreactive monomer or plasticizer, etc.) contained in the photopolymer layer, and minimize the decrease in recording properties for optical information.

In order to adjust the crosslinking density of the acrylic-based polyol by the siloxane-based polymer at a level that is advantageous for ensuring the function of the hologram recording medium, the hydroxyl group equivalent of the acrylic-based polyol may be adjusted to an appropriate level.

Specifically, the hydroxyl group (-OH) equivalent of the acrylic-based polyol may be, for example, in the range of 500 to 3,000 g/equivalent. More specifically, the lower limit of the hydroxyl group (-OH) equivalent of the acrylic-based polyol may be 600 g/equivalent or more, 700 g/equivalent or more, 800 g/equivalent or more, 900 g/equivalent or more, 1000 g/equivalent or more, 1100 g/equivalent or more, 1200 g/equivalent or more, 1300 g/equivalent or more, 1400 g/equivalent or more, 1500 g/equivalent or more, 1600 g/equivalent or more, 1700 g/equivalent or more, or 1750 g/equivalent or more. And, the upper limit of the hydroxyl group (-OH) equivalent of the acrylic-based polyol may be 2900 g/equivalent or less, 2800 g/equivalent or less, 2700 g/equivalent or less, 2600 g/equivalent or less, 2500 g/equivalent or less, 2400 g/equivalent or less, 2300 g/equivalent or less, 2200 g/equivalent or less, 2100 g/equivalent or less, 2000 g/equivalent or less, or 1900 g/equivalent or less. The hydroxyl group (-OH) equivalent of the acrylic-based polyol means the equivalent weight (g/equivalent) for each single hydroxyl group, and is the value obtained by dividing the weight average molecular weight of the acrylic-based polyol by the number of hydroxyl groups per molecule. Therefore, as the equivalent value is smaller, the density of the functional group is higher, and as the equivalent value is larger, the density of the functional group is smaller. When the hydroxyl (-OH) equivalent of the acrylic-based polyol satisfies the above range, the polymer matrix has an appropriate crosslinking density and thus, sufficiently performs the role of a support, and the mobility of the components included in the photopolymer layer is improved, which allows the initial refractive index modulation value to be maintained at an excellent level even as time passes without the problem of collapsing the boundary surfaces of the diffraction gratings generated after recording, thereby minimizing the decrease in recording properties for optical information.

For example, the acrylic-based polyol may have a glass transition temperature (Tg) in the range of -60 to -10°C. Specifically, the lower limit of the glass transition temperature may be, for example, -55°C or more, -50°C or more, -45°C or more, -40°C or more, -35°C or more, -30°C or more, or -25°C or more, and the upper limit thereof may be, for example, -15°C or less, -20°C or less, -25°C or less, -30°C or less, or -35°C or less. If the above glass transition temperature range is satisfied, it is possible to lower the glass transition temperature without significantly reducing the modulus of the polymer matrix, thereby increasing the mobility (fluidity) of other components in the photopolymer composition, and also improving the moldability of the photopolymer composition. The glass transition temperature may be measured using a known method, for example, DSC (Differential Scanning Calorimetry) or DMA (dynamic mechanical analysis).

The refractive index of the acrylic-based polyol may be, for example, 1.40 or more and less than 1.50. Specifically, the lower limit of the refractive index of the acrylic-based polyol may be, for example, 1.41 or more, 1.42 or more, 1.43 or more, 1.44 or more, 1.45 or more, or 1.46 or more, and the upper limit thereof may be, for example, 1.49 or less, 1.48 or less, 1.47 or less, 1.46 or less, or 1.45 or less. When the acrylic-based polyol has a refractive index within the above-mentioned range, it can contribute to increasing the refractive index modulation. The refractive index of the acrylic-based polyol is a theoretical refractive index, and may be calculated using the refractive index (value measured using an Abbe refractometer at 25°C) of the monomer used for preparing the acrylic-based polyol and the fraction (molar ratio) of each monomer.

The acrylic-based polyol and the siloxane-based polymer may be included so that the molar ratio (SiH/OH) of the

silane functional group (Si-H) of the siloxane-based polymer to the hydroxyl group (-OH) of the (meth)acrylic-based polyol is 0.80 to 3.5. That is, the type and content of the siloxane-based polymer and the acrylic-based polyol may be selected so as to satisfy the molar ratio when forming the polymer matrix. The lower limit of the molar ratio (SiH/OH) may be, for example, 0.81 or more, 0.85 or more, 0.90 or more, or 0.95 or more, and the upper limit thereof may be, for example, 3.4 or less, 3.3 or less, 3.2 or less, 3.1 or less, 3.05 or less, or 3.0 or less. When satisfying the above molar ratio (SiH/OH) range, the polymer matrix is crosslinked at an appropriate crosslinking density, so that reliability under high temperature conditions is improved, and a sufficient refractive index modulation value can be realized.

The Pt-based catalyst may be, for example, Karstedt's catalyst, and the like. The precursor of the polymer matrix may optionally further include rhodium-based catalysts, iridium-based catalysts, rhenium-based catalysts, molybdenum-based catalysts, iron-based catalysts, nickel-based catalysts, alkali metal or alkaline earth metal-based catalysts, Lewis acids-based or carbene-based non-metallic catalysts, in addition to the Pt-based catalyst.

On the other hand, optical information can be recorded by irradiating an object light and a reference light onto the hologram recording medium of one embodiment. Due to the interference field between the object light and the reference light, photopolymerization of the photoreactive monomer does not occur in the destructive interference region, but photopolymerization of the photoreactive monomer occurs in the constructive interference region. As the photoreactive monomer is continuously consumed in the constructive interference region, a concentration difference occurs between the photoreactive monomer in the destructive interference region and the constructive interference region, and as a result, the photoreactive monomer in the destructive interference region diffuses into the constructive interference region. A diffraction grating is generated by the refractive index modulation thus generated.

Therefore, the photoreactive monomer may include a compound having a higher refractive index than the polymer matrix in order to realize the above-described refractive index modulation. However, all photoreactive monomers contained in the photopolymer composition according to one embodiment of the disclosure are not limited to those having a higher refractive index than the polymer matrix, and at least a part of the photoreactive monomers may have a higher refractive index than the polymer matrix, so as to realize a high refractive index modulation value. In one example, the photoreactive monomer may include a monomer having a refractive index of 1.50 or more, 1.51 or more, 1.52 or more, 1.53 or more, 1.54 or more, 1.55 or more, 1.56 or more, 1.57 or more, 1.58 or more, 1.59 or more, or 1.60 or more, and 1.70 or less.

The photoreactive monomer may include at least one monomer selected from the group consisting of a monofunctional monomer having one photoreactive functional group and a polyfunctional monomer having two or more photoreactive functional groups. Wherein, the photoreactive functional group may be, for example, a (meth)acryloyl group, a vinyl group, a thiol group, or the like. More specifically, the photoreactive functional group may be a (meth)acryloyl group.

The monofunctional monomer may include, for example, at least one selected from the group consisting of benzyl (meth)acrylate (M1182 having a refractive index of 1.5140, Miwon Specialty Chemical), benzyl 2-phenylacrylate, phenoxybenzyl (meth)acrylate (M1122 having a refractive index of 1.565, Miwon Specialty Chemical), phenol (ethylene oxide) (meth)acrylate (phenol (EO) (meth)acrylate, M140 having a refractive index of 1.516, Miwon Specialty Chemical), phenol (ethylene oxide)$_2$ (meth)acrylate (phenol (EO)$_2$ (meth)acrylate; M142 having a refractive index of 1.510, Miwon Specialty Chemical), O-phenylphenol (ethylene oxide) (meth)acrylate (O-phenylphenol (EO) (meth)acrylate; M1142 having a refractive index of 1.577, Miwon Specialty Chemical), phenylthioethyl (meth)acrylate (M1162 having a refractive index of 1.560, Miwon Specialty Chemical) and biphenylmethyl (meth)acrylate.

The polyfunctional monomer may include, for example, at least one selected from the group consisting of bisphenol A (ethylene oxide)$_{2\sim10}$ di(meth)acrylate (bisphenol A (EO)$_{2\sim10}$ (meth)acrylate; M240 having a refractive index of 1.537, M241 having a refractive index of 1.529, M244 having a refractive index of 1.545, M245 having a refractive index of 1.537, M249 having a refractive index of 1.542, M2100 having a refractive index of 1.516, M2101 having a refractive index of 1.512, Miwon Specialty Chemical), bisphenol A epoxy di(meth)acrylate (PE210 having a refractive index of 1.557, PE2120A having a refractive index of 1.533, PE2120B having a refractive index of 1.534, PE2020C having a refractive index of 1.539, PE2120S having a refractive index of 1.556, Miwon Specialty Chemical), bisfluorene di(meth)acrylate (HR6022 having a refractive index of 1.600, HR6040 having a refractive index of 1.600, HR6042 having a refractive index of 1.600, Miwon Specialty Chemical), modified bisphenol fluorene di(meth)acrylate (HR6060 having a refractive index of 1.584, HR6100 having a refractive index of 1.562, HR6200 having a refractive index of 1.530, Miwon Specialty Chemical), tris(2-hydroxyethyl)isocyanurate tri(meth)acrylate (M370 having a refractive index of 1.508, Miwon Specialty Chemical), phenol novolac epoxy (meth)acrylate (SC6300 having a refractive index of 1.525, Miwon Specialty Chemical) and cresol novolac epoxy (meth)acrylate (SC6400 having a refractive index of 1.522, SC6400C having a refractive index of 1.522, Miwon Specialty Chemical).

The photopolymer layer may contain a photoreactive monomer in an amount of 50 to 300 parts by weight based on 100 parts by weight of the polymer matrix. For example, the lower limit of the content of the photoreactive monomer may be 50 parts by weight or more, 60 parts by weight or more, 70 parts by weight or more, 80 parts by weight or more, or 90 parts by weight or more, and the upper limit thereof may be 300 parts by weight or less, 280 parts by weight or less, 250

parts by weight or less, 220 parts by weight or less, 200 parts by weight or less, 190 parts by weight or less, or 180 parts by weight or less. When the above range is satisfied, it is advantageous for ensuring excellent optical recording characteristics and durability under high temperature conditions.

In this specification, the content of the polymer matrix means the total content (weight) of the acrylic-based polyol and siloxane-based polymer forming the matrix. In other words, the content of the polymer matrix means including both the content of the polymer matrix formed by crosslinking acrylic-based polyol and siloxane-based polymer and the content of the polymer matrix precursor that is not partially crosslinked.

The photopolymer layer includes a photoinitiator system or a photopolymer polymerized by the photoinitiator system. The photoinitiator system means a combination of a photosensitizing dye and a co-initiator that enables polymerization to initiate by light.

The hologram recording medium of one embodiment includes a photosensitizing dye for the red region, a photosensitizing dye for the green region, and a photosensitizing dye for the blue region as a photosensitizing dye, thereby enabling optical recording in all three regions, red, green, and blue.

A "photosensitizing dye for the red region," "photosensitizing dye for the green region," and "photosensitizing dye for the blue region" each refers to a dye selectively responsive to light in the red, green, or blue region. Among the visible light range of 400 to 700 nm, the red region may be, for example, a wavelength region of 600 to 700 nm, 600 to 680 nm, 600 to 670 nm, 600 to 660 nm, 600 to 650 nm, or 600 to 640 nm; the green region may be, for example, a wavelength region of 490 to 570 nm, 490 to 560 nm, 490 to 550 nm, 490 to 540 nm, or 492 to 535 nm; and the blue region may be, for example, a wavelength region of 400 to 480 nm, 400 to 470 nm, 410 to 470 nm, 410 to 460 nm, or 420 to 460 nm.

In the case of conventional hologram recording media capable of optical recording in the blue region, the realism or visibility of the holographic image tends to be reduced due to low transparency. However, the hologram recording medium according to one embodiment can exhibit high transparency by employing a compound having a specific structure as the photosensitizing dye for the blue region.

The photosensitizing dye for the blue region may include, for example, a cation-containing compound represented by the following Chemical Formula 3.

[Chemical Formula 3]

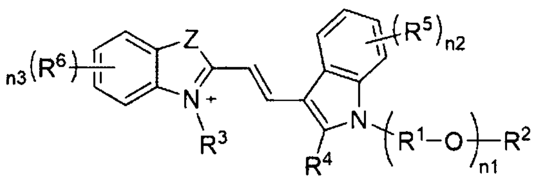

in Chemical Formula 3,

- $R^1$ is an alkylene group having 1 to 6 carbon atoms, $R^2$ is an alkyl group having 1 to 6 carbon atoms,
- n1 is an integer of 1 to 6,
- $R^3$ is an alkyl group having 3 to 12 carbon atoms,
- $R^4$ is hydrogen or an alkyl group having 1 to 6 carbon atoms,
- $R^5$ and $R^6$ are each independently a halogen, a hydroxyl group, an alkyl group having 1 to 6 carbon atoms, or an alkoxy group having 1 to 6 carbon atoms,
- n2 and n3 are each independently an integer of 0 to 4,
- Z is oxygen, sulfur, or $CR^7R^8$
- $R^7$ and $R^8$ are each independently an alkyl group having 1 to 6 carbon atoms.

In Chemical Formula 3, $R^1$ may be, for example, methylene group, 1,2-ethylene group, 1,3-propylene group, 1,2-propylene group, 1,4-butylene group, 1,3-butylene group, 1,2-butylene group, or isobutylene group. Specifically, $R^1$ may be, for example, 1,2-ethylene group, 1,2-propylene group, or isobutylene group. More specifically, $R^1$ may be, for example, 1,2-ethylene group.

In Chemical Formula 3, $R^2$ may be, for example, methyl, ethyl, n-propyl, isopropyl, 1-butyl, 2-butyl, isobutyl, or t-butyl. Specifically, $R^2$ may be, for example, methyl, ethyl, or n-propyl. More specifically, $R^2$ may be, for example, methyl.

In Chemical Formula 3, n1 may be, for example, an integer of 1 to 4, an integer of 1 to 3, or an integer of 1 to 2.

In Chemical Formula 3, $R^3$ may be, for example, a branched chain or cyclic alkyl group having 3 to 12 carbon atoms. Specifically, $R^3$ may be, for example, isopropyl, isobutyl, t-butyl, isopentyl, 1-methyl-1-butyl, 2-methyl-2-butyl, t-pentyl, isohexyl, 1-methyl-1-pentyl, 2-methyl-1-pentyl, 3-methyl-1-pentyl, t-hexyl, 2,2-dimethyl-1-butyl, 3,3-dimethyl-1-butyl, cyclopropyl, cyclobutyl, cyclopentyl, cyclohexyl, cyclopropylmethyl, cyclobutylmethyl, cyclopentylmethyl, cyclohexylmethyl, cyclopropylethyl, cyclobutylethyl, cyclopentylethyl, or cyclohexylethyl. More specifically, $R^3$ may be, for example, isopropyl, isobutyl, t-butyl, isopentyl, isohexyl, 2,2-dimethyl-1-butyl, or 3,3-dimethyl-1-butyl.

In Chemical Formula 3, $R^4$ may be, for example, hydrogen, methyl group, or ethyl group. More specifically, $R^4$ may be, for example, hydrogen.

In Chemical Formula 3, $R^5$ and $R^6$ may be, for example, each independently halogen, hydroxyl group, an alkyl group having 1 to 6 carbon atoms, or an alkoxy group having 1 to 6 carbon atoms. More specifically, $R^5$ and $R^6$ may be, for example, each independently fluorine, chlorine, methyl, ethyl, methoxy, or ethoxy.

In Chemical Formula 3, n2 and n3 may be, for example, each independently an integer of 0 to 4, an integer of 0 to 3, an integer of 0 to 2, an integer of 0 to 1, or 0.

In Chemical Formula 3, Z may be, for example, oxygen, sulfur, or $CR^7R^8$, wherein $R^7$ and $R^8$ may be, for example, each independently an alkyl group having 1 to 3 carbon atoms. Specifically, Z may be, for example, oxygen, sulfur, or 2,2-propylene group. More specifically, Z may be, for example, 2,2-propylene group.

The cation-containing compound represented by Chemical Formula 3 may include the cation represented by Chemical Formula 3 and an anion. The type of anion is not particularly limited, and may be, for example, a tetraaryl borate. The four aryl groups of the tetraaryl borate may be the same or different from each other, and may be, for example, a substituted or unsubstituted aryl group having 6 to 30 carbon atoms, a substituted or unsubstituted arylalkyl group having 7 to 30 carbon atoms, or a substituted or unsubstituted alkylaryl group having 7 to 30 carbon atoms.

In this specification, "substituted or unsubstituted" means that hydrogen or carbon is substituted by another atom unless otherwise defined. In one example, hydrogen may be substituted by a halogen, a vinyl group, a hydroxy group, an alkyl group having 1 to 10 carbon atoms, a haloalkyl group having 1 to 10 carbon atoms, or an alkoxy group having 1 to 10 carbon atoms, and carbon ($-CH_2-$) may be substituted by -O- or -CO-.

In one example, the tetraaryl borate may be at least one anion selected from the group consisting of tetra(phenyl) borate, tetrakis(fluorophenyl) borate, tetrakis(chlorophenyl) borate, tetrakis(methylphenyl) borate, tetrakis(methoxyphenyl) borate, tetrakis(fluoromethylphenyl) borate, tetrakis(fluoromethoxyphenyl) borate, tetrakis(chloromethylphenyl) borate, and tetrakis(chloromethoxyphenyl) borate.

Even when the photosensitizing dye for the blue region is used in an amount sufficient to achieve excellent optical recording characteristics, it can still provide a highly transparent hologram recording medium. In one example, the photosensitizing dye for the blue region may be contained in an amount of 0.01 to 10 parts by weight based on 100 parts by weight of the polymer matrix. Specifically, the lower limit of the content of the photosensitizing dye for the blue region may be, for example, 0.02 parts by weight or more, 0.03 parts by weight or more, or 0.05 parts by weight or more, and the upper limit may be, for example, 5 parts by weight or less. When the above range is satisfied, it can exhibit more excellent optical recording characteristics in the blue region while ensuring high transparency in the hologram recording medium.

The hologram recording medium according to one embodiment can also exhibit high optical recording characteristics and transparency by using a particular compound as the photosensitizing dye for the red region.

The photosensitizing dye for the red region may include, for example, a silicon rhodamine compound represented by the following Chemical Formula 4.

[Chemical Formula 4]

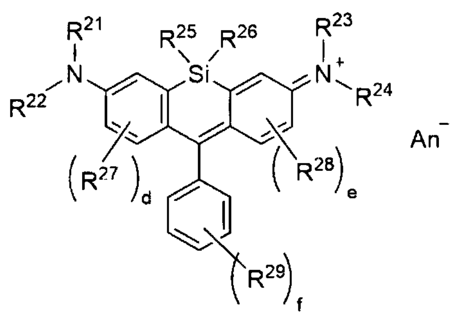

in Chemical Formula 4,

$R^{21}$ to $R^{29}$ are each independently hydrogen, a substituted or unsubstituted alkyl group having 1 to 20 carbon atoms, a substituted or unsubstituted alkoxy group having 1 to 20 carbon atoms, a substituted or unsubstituted aryl group having 6 to 30 carbon atoms, or a substituted or unsubstituted aryloxy group having 6 to 30 carbon atoms,
d and e are each independently an integer of 0 to 3,
f is an integer of 0 to 5, and
$An^-$ is an anion.

In Chemical Formula 4, $R^{21}$ to $R^{28}$ may be each independently a substituted or unsubstituted alkyl group having 1 to 20 carbon atoms. Specifically, in Chemical Formula 4, $R^{21}$ to $R^{28}$ may be each independently an alkyl group having 1 to 6 carbon atoms. More specifically, in Chemical Formula 4, $R^{21}$ to $R^{28}$ may be methyl groups.

In Chemical Formula 4, d and e may be each independently an integer of 0 to 2, an integer of 0 to 1, or 0.

In Chemical Formula 4, f may be an integer of 0 to 5, an integer of 0 to 4, an integer of 0 to 3, an integer of 0 to 2, or an integer of 1 to 2.

In Chemical Formula 4, $R^{29}$ may be a substituted or unsubstituted alkoxy group having 1 to 20 carbon atoms. Specifically, in Chemical Formula 4, $R^{29}$ may be an alkoxy group having 1 to 6 carbon atoms. More specifically, in Chemical Formula 4, $R^{29}$ may be a methoxy group.

In Chemical Formula 4, the anion ($An^-$) may be a halide anion, a cyano anion, a sulfonate anion, an alkoxy anion having 1 to 30 carbon atoms, a substituted or unsubstituted alkyl sulfonate anion having 1 to 30 carbon atoms, a substituted or unsubstituted aromatic sulfonate anion having 6 to 30 carbon atoms, or a substituted or unsubstituted aromatic borate anion having 6 to 30 carbon atoms.

Specifically, in Chemical Formula 4, the anion ($An^-$) may be a substituted or unsubstituted alkyl sulfonate anion having 1 to 30 carbon atoms, a substituted or unsubstituted aromatic sulfonate anion having 6 to 30 carbon atoms, or a substituted or unsubstituted aromatic borate anion having 6 to 30 carbon atoms.

More specifically, in Chemical Formula 4, the anion ($An^-$) may be an alkyl sulfonate anion having 2 to 15 carbon atoms in which at least one hydrogen is substituted or unsubstituted with fluorine, an alkyl sulfonate anion having 6 to 30 carbon atoms in which at least one carbon is substituted or unsubstituted with -O- or -CO-, a phenyl sulfonate anion substituted or unsubstituted with methyl, or a substituted or unsubstituted tetraaryl borate anion. In one example, in Chemical Formula 4, the anion ($An^-$) may be dodecyl sulfonate anion, perfluorobutyl sulfonate anion, phenyl sulfonate anion, methylphenyl sulfonate anion,

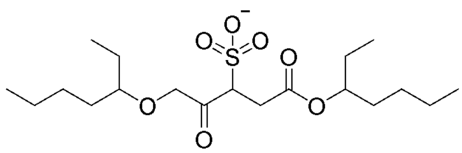

,

or tetraphenylborate anion.

Even when the photosensitizing dye for the red region is used in an amount sufficient to achieve excellent optical recording characteristics, it can still provide a highly transparent hologram recording medium. In one example, the photosensitizing dye for the red region may be contained in an amount of 0.01 to 10 parts by weight based on 100 parts by weight of the polymer matrix. Specifically, the lower limit of the content of the photosensitizing dye for the red region may be, for example, 0.02 parts by weight or more, 0.03 parts by weight or more, or 0.05 parts by weight or more, and the upper limit may be, for example, 5 parts by weight or less. When the above range is satisfied, it can exhibit more excellent optical recording characteristics in the red region while ensuring high transparency in the hologram recording medium.

The hologram recording medium according to one embodiment can exhibit high optical recording characteristics and transparency by using a particular compound as the photosensitizing dye for the green region.

The photosensitizing dye for the green region may include, for example, at least one compound selected from the group consisting of a compound represented by the following Chemical Formula 5, a compound represented by the following Chemical Formula 6, thioerythrosine triethylammonium and erythrosin B.

[Chemical Formula 5]

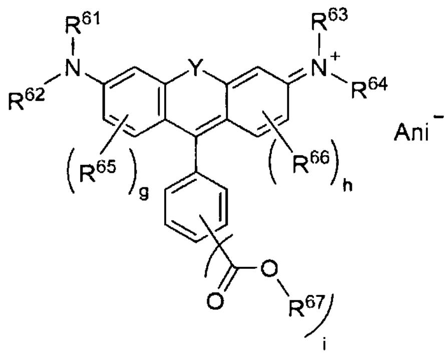

in Chemical Formula 5,

Y is O or S,
$R^{61}$ to $R^{66}$ are each independently hydrogen or a substituted or unsubstituted alkyl group having 1 to 20 carbon atoms,
$R^{67}$ is a substituted or unsubstituted alkyl group having 1 to 20 carbon atoms,
g and h are each independently an integer of 0 to 3,
i is an integer of 0 to 5, and
$Ani^-$ is an anion.

[Chemical Formula 6]

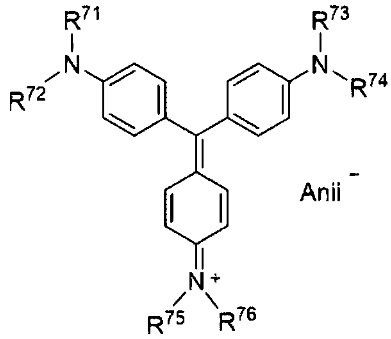

in Chemical Formula 6,
$R^{71}$ to $R^{77}$ are each independently a substituted or unsubstituted alkyl group having 1 to 20 carbon atoms, and
$Anii^-$ is an anion.

In Chemical Formula 5, $R^{61}$ to $R^{66}$ may be each independently hydrogen or a substituted or unsubstituted alkyl group having 1 to 20 carbon atoms. Specifically, in Chemical Formula 5, $R^{61}$ to $R^{66}$ may be each independently hydrogen, methyl, ethyl, propyl, butyl, pentyl, or hexyl. More specifically, in Chemical Formula 5, $R^{61}$ and $R^{63}$ may be hydrogen, and $R^{62}$ and $R^{64}$ to $R^{66}$ may be each independently methyl or ethyl.

In Chemical Formula 5, $R^{67}$ may be a substituted or unsubstituted alkyl group having 1 to 20 carbon atoms. Specifically, in Chemical Formula 5, $R^{67}$ may be methyl, ethyl, propyl, butyl, pentyl, or hexyl. More specifically, in Chemical Formula 5, $R^{67}$ may be methyl or ethyl.

In Chemical Formula 5, g and h may be each independently an integer of 0 to 2, an integer of 1 to 2, or 1.

In Chemical Formula 5, i may be an integer of 0 to 5, an integer of 0 to 4, an integer of 0 to 3, an integer of 0 to 2, or an integer of 1 to 2.

In Chemical Formula 5, the anion ($Ani^-$) may be a halide anion, a cyano anion, a sulfonate anion, a bistriflimide anion, an alkoxy anion having 1 to 30 carbon atoms, a substituted or unsubstituted alkyl sulfonate anion having 1 to 30 carbon atoms, a substituted or unsubstituted aromatic sulfonate anion having 6 to 30 carbon atoms, or a substituted or unsubstituted aromatic borate anion having 6 to 30 carbon atoms.

Specifically, in Chemical Formula 5, the anion ($Ani^-$) may be a halide anion, a bistriflimide anion, a substituted or unsubstituted alkyl sulfonate anion having 1 to 30 carbon atoms, a substituted or unsubstituted aromatic sulfonate anion having 6 to 30 carbon atoms, or a substituted or unsubstituted aromatic borate anion having 6 to 30 carbon atoms.

More specifically, in Chemical Formula 5, the anion ($Ani^-$) may be a chloride anion, a bistriflimide anion, an unsubstituted alkyl sulfonate anion having 2 to 15 carbon atoms, a phenyl sulfonate anion in which at least one hydrogen is substituted or unsubstituted with a methyl group, or a substituted or unsubstituted tetraarylborate anion. In one example, in Chemical Formula 5, the anion ($Ani^-$) may be a chloride anion, a bistriflimide anion, a hexyl sulfonate anion, a dodecyl sulfonate anion, a methylphenyl sulfonate anion, or a tetraphenylborate anion.

In Chemical Formula 6, $R^{71}$ to $R^{76}$ may be each independently a substituted or unsubstituted alkyl group having 1 to 20 carbon atoms. Specifically, in Chemical Formula 6, $R^{71}$ to $R^{76}$ may be each independently a methyl group, an ethyl group, a propyl group, a butyl group, a pentyl group, or a hexyl group. More specifically, in Chemical Formula 6, $R^{71}$ to $R^{76}$ may be each independently a methyl group or an ethyl group.

In Chemical Formula 6, the anion ($Anii^-$) may be a halide ion, a cyano ion, a sulfonate ion, a bistriflimide ion, an alkoxy ion having 1 to 30 carbon atoms, a substituted or unsubstituted alkyl sulfonate ion having 1 to 30 carbon atoms, a substituted or unsubstituted aromatic sulfonate ion having 6 to 30 carbon atoms, or a substituted or unsubstituted aromatic borate ion having 6 to 30 carbon atoms.

Specifically, in Chemical Formula 6, the anion ($Anii^-$) may be a halide anion, a bistriflimide anion, a substituted or

unsubstituted alkyl sulfonate anion having 1 to 30 carbon atoms, a substituted or unsubstituted aromatic sulfonate anion having 6 to 30 carbon atoms, or a substituted or unsubstituted aromatic borate anion having 6 to 30 carbon atoms.

More specifically, in Chemical Formula 6, the anion ($Anii^-$) may be a halide anion. In one example, in Chemical Formula 6, the anion ($Anii^-$) may be a chloride anion.

Even when the photosensitizing dye for the green region is used in an amount sufficient to achieve excellent optical recording characteristics, it can still provide a highly transparent hologram recording medium. In one example, the photosensitizing dye for the green region may be contained in an amount of 0.01 to 10 parts by weight based on 100 parts by weight of the polymer matrix. Specifically, the lower limit of the content of the photosensitizing dye for the green region may be, for example, 0.02 parts by weight or more, 0.03 parts by weight or more, or 0.05 parts by weight or more, and the upper limit may be, for example, 5 parts by weight or less. When the above range is satisfied, it can exhibit more excellent optical recording characteristics in the blue region while ensuring high transparency in the hologram recording medium.

The co-initiator may include an electron donor, an electron acceptor, or a mixture thereof.

In one example, the co-initiator may include an electron donor. The electron donor may include, for example, a borate anion represented by the following Chemical Formula 7.

[Chemical Formula 7] $BX^1X^2X^3X^4$

in Chemical Formula 7, $X^1$ to $X^4$ are each independently an alkyl group having 1 to 20 carbon atoms, an alkenyl group having 2 to 20 carbon atoms, an aryl group having 6 to 30 carbon atoms, an arylalkyl group having 7 to 30 carbon atoms, an alkylaryl group having 7 to 30 carbon atoms, or an allyl group, each of which is substituted or unsubstituted, with the proviso that at least one of $X^1$ to $X^4$ is not an aryl group.

When the alkyl group having 1 to 20 carbon atoms, the alkenyl group having 2 to 20 carbon atoms, the aryl group having 6 to 30 carbon atoms, the arylalkyl group having 7 to 30 carbon atoms, the alkylaryl group having 7 to 30 carbon atoms, or the allyl group is substituted, it may be substituted with at least one selected from the group consisting of a halogen, a vinyl group, a haloalkyl group having 1 to 5 carbon atoms, and an alkoxy group having 1 to 5 carbon atoms.

Specifically, $X^1$ to $X^3$ may be each independently methyl, ethyl, propyl, n-butyl, n-pentyl, n-hexyl, cyclobutyl, cyclopentyl, cyclohexyl, ethenyl, propenyl, phenyl, methylphenyl, methoxyphenyl, naphthyl, methylnaphthyl, or methoxynaphthyl, which is substituted or unsubstituted with halogen, and $X^4$ may be n-butyl, n-pentyl, or n-hexyl. More specifically, the borate anion represented by Chemical Formula 7 may be, for example, a triphenylbutyl borate anion.

The cation bonded to the borate anion does not absorb light, and may be an alkali metal cation, or a quaternary ammonium cation. The quaternary ammonium cation may be an ammonium cation in which nitrogen (N) is substituted with four substituents, and the four substituents are each independently an alkyl group having 1 to 40 carbon atoms, an aryl group having 6 to 30 carbon atoms, an arylalkyl group having 6 to 40 carbon atoms, or an alkyl group having 2 to 40 carbon atoms connected through an ester bond (e.g., $-CH_2CH_2-O-CO-CH_2CH_2CH_3$, etc.).

As the electron donor, for example, commercially available butyryl choline triphenylbutylborate (Borate V, manufactured by Spectra Group) may be used.

In one example, the co-initiator may include an electron acceptor. The electron acceptor may include, for example, onium salts such as sulfonium salts and iodonium salts; triazine compounds such as tris(trihalomethyl)triazine, substituted bis(trihalomethyl)triazine, etc.; or a mixture thereof.

Specifically, the electron acceptor may include (4-(octyloxy)phenyl)(phenyl)iodonium salt as an iodonium salt, or 2-(4-methoxyphenyl)-4,6-bis(trichloromethyl)-1,3,5-triazine as the triazine compound. Examples of the electron acceptor include commercially available H-Nu 254 (Spectra Group) or 2-(4-methoxyphenyl)-4,6-bis(trichloromethyl)-1,3,5-triazine (TCI America).

The co-initiator may be contained, for example, in an amount of 0.05 to 50 parts by weight based on 100 parts by weight of the polymer matrix. Specifically, the lower limit of the content of the co-initiator may be, for example, 0.1 part by weight or more, 0.5 part by weight or more, 1 part by weight or more, 1.5 part by weight or more, or 2 part by weight or more, and the upper limit thereof may be, for example, 30 parts by weight or less. When the above range is satisfied, it is advantageous for exhibiting an appropriate polymerization reaction rate and ensuring the desired optical recording properties.

The photoinitiator system may include an additional photoinitiator in order to remove the color of the photosensitizing dye and react all unreacted photoreactive monomers after light irradiation for recording. The photoinitiator may include, for example, acetophenone-based compounds, oxime-based compounds, phosphine oxide-based compounds, thioxanthone-based compounds, benzoate-based compounds, imidazole-based compounds, N-aryl glycine derivatives, organic azide compounds, titanocenes, aluminate complexes, organic peroxides, N-alkoxy pyridinium salts, amine derivatives, diazonium salts, sulfonium salts, iodonium salts, sulfonates, imide sulfonates, dialkyl-4-hydroxysulfonium salts, aryl sulfonic acid-p-nitrobenzyl esters, silanol-aluminum complexes, (η6-benzene) (η5-cyclopentadienyl)iron(II), benzoin tosylate, 2,5-dinitrobenzyl tosylate, N-tosylphthalimide, or mixtures thereof, etc.

More specifically, the photoinitiator may include 2-methyl-1-[4-(methylthio)phenyl]-2-morpholinopropan-1-one,

2-benzyl-2-dimethylamino-1-(4-morpholinophenyl)-butan-1-one (Irgacure 369), 1-[9-ethyl-6-(2-methylbenzoyl)-9H-carbazol-3-yl]ethanone-1-(O-acetyl oxime) (Irgacure OXE02, BASF), [(Z)-(1-oxo-1-phenylpropan-2-ylidene)amino] benzoate (e.g., TPI-057 or TPI-059, manufactured by TREEEL), diphenyl(2,4,6-trimethylbenzoyl)phosphine oxide (Irgacure TPO), bis(2,6-dimethoxybenzoyl)-2,4,4-trimethylpentyl phosphine oxide (Irgacure 1700), phenylbis(2,4,6-trimethylbenzoyl)phosphine oxide (BAPO), bis(2,4,6-trimethylbenzoyl)phenylphosphine oxide (Irgacure 819), 2,4-diethyl thioxanthone, 2-chloro thioxanthone, isopropyl thioxanthone, diisopropyl thioxanthone, ethyl 4-(dimethylamino)benzoate, 1,3-di(t-butyldioxycarbonyl)benzophenone, 3,3',4,4"-tetrakis(t-butyldioxycarbonyl)benzophenone, 3-phenyl-5-isoxazoline, 2-mercaptobenzimidazole, bis(2,4,5-triphenyl)imidazole, 2,2-dimethoxy-1,2-diphenylethan-1-one (Irgacure 651), 1-hydroxycyclohexyl phenyl ketone (Irgacure 184), bis(η5-2,4-cyclopentadien-1-yl)-bis(2,6-difluoro-3-(1H-pyrrol-1-yl)phenyl)titanium (Irgacure 784), Ebecryl P-115 (SK entis), Cyracure UVI-6970, Cyracure UVI-6974, Cyracure UVI-6990 (Dow Chemical Co. in the USA), Irgacure 264, Irgacure 250 (BASF), CIT-1682 (Nippon Soda), or mixtures thereof, but are not limited thereto.

The hologram recording medium of one embodiment may further include a plasticizer. When a plasticizer is added to the photopolymer layer, refractive index modulation can be more easily realized upon recording a hologram. More specifically, the plasticizer lowers the glass transition temperature of the polymer matrix, improves the mobility of the photoreactive monomer, and has a low refractive index and non-reactive properties. Thus, when a photoreactive monomer that is uniformly distributed within the polymer matrix but is not photopolymerized moves, it can move in the direction opposite thereto and contribute to the refractive index modulation. Further, the plasticizer can also contribute to improving the moldability of photopolymer compositions.

The photopolymer layer may include a fluorinated compound as a plasticizer.

The fluorinated compound may have a low refractive index of 1.45 or less in order to perform the above-described plasticizer function. Specifically, the upper limit of the refractive index may be, for example, 1.44 or less, 1.43 or less, 1.42 or less, 1.41 or less, 1.40 or less, 1.39 or less, 1.38 or less, or 1.37 or less, and the lower limit of the refractive index may be, for example, 1.30 or more, 1.31 or more, 1.32 or more, 1.33 or more, 1.34 or more, or 1.35 or more. Since a fluorinated compound having a lower refractive index than the above-mentioned photoreactive monomer is used, the refractive index of the polymer matrix can be further lowered, and the refractive index modulation with the photoreactive monomer can be made larger.

The fluorinated compound may include, for example, at least one functional group selected from the group consisting of an ether group, an ester group and an amide group, and two or more difluoromethylene groups. More specifically, the fluorinated compound may be, for example, a compound containing a repeating unit represented by the following Chemical Formula 8.

[Chemical Formula 8]

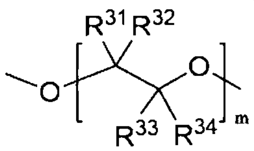

in Chemical Formula 8,

a plurality of $R^{31}$ to $R^{34}$ are each independently hydrogen or fluorine, with the proviso that at least one of $R^{31}$ to $R^{34}$ is fluorine, and m is an integer of 2 to 12.

More specifically, the fluorinated compound may be a compound containing 1 to 3 units represented by the following Chemical Formula 8-1.

[Chemical Formula 8-1]

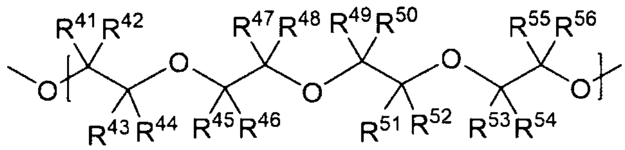

in Chemical Formula 8-1,

$R^{41}$ to $R^{44}$ and $R^{53}$ to $R^{56}$ are each independently hydrogen or fluorine, and $R^{45}$ to $R^{52}$ are fluorine.

In one example, in Chemical Formula 8-1, $R^{41}$, $R^{42}$, $R^{55}$, and $R^{56}$ are hydrogen, and $R^{43}$ to $R^{34}$ are fluorine.

The fluorinated compound containing (repeating) units represented by Chemical Formulas 8 and 8-1 are not particularly limited, but can be capped with an end capping agent widely used in the related technical field. In one example, the terminal end of the fluorinated compound containing the (repeating) unit represented by Chemical Formulas 8 and 8-1 may be an alkyl group or an alkyl group substituted with at least one alkoxy. By way of non-limiting example, 2-methoxyethoxymethyl chloride is used as an end capping agent and thus, the terminal end of the fluorinated compound containing the (repeating) unit represented by Chemical Formulas 8 and 8-1 may be a 2-methoxyethoxymethyl group.

The fluorinated compound may have a weight average molecular weight of 300 or more. Specifically, the lower limit of the weight average molecular weight of the fluorinated compound may be, for example, 350 or more, 400 or more, 450 or more, 500 or more, or 550 or more, and the upper limit thereof may be, for example, 1000 or less, 900 or less, 800 or less, 700 or less, or 600 or less. Considering refractive index modulation, compatibility with other components, elution problems of fluorinated compounds, and the like, it is preferable that the above weight average molecular weight range is satisfied. At this time, the weight average molecular weight means the weight average molecular weight in terms of polystyrene measured by the GPC method as described above.

The photopolymer layer may include 20 to 200 parts by weight of the fluorinated compound based on 100 parts by weight of the polymer matrix. Specifically, the lower limit of the content of the fluorinated compound may be, for example, 25 parts by weight or more, 30 parts by weight or more, 40 parts by weight or more, 50 parts by weight or more, 60 parts by weight or more, 70 parts by weight or more, or 80 parts by weight or more, and the upper limit thereof may be, for example, 190 parts by weight or less, 180 parts by weight or less, 170 parts by weight or less, 160 parts by weight or less, or 150 parts by weight or less. When the above range is satisfied, it can represent large refractive index modulation values after recording due to fluorinated compounds having sufficient low refractive index, without problems of deteriorating the compatibility with the components contained in the photopolymer layer, of eluting some fluorinated compounds to the surface of the photopolymer layer, or of degrading haze, which are thus advantageous for ensuring excellent optical recording characteristics.

The hologram recording medium of one embodiment may further include additives such as a surfactant or an antifoaming agent.

The surfactant may be, for example, a silicone-based surfactant, a fluorine-based surfactant, or a mixture thereof.

As the silicone-based surfactant, for example, BYK-077, BYK-085, BYK-300, BYK-301, BYK-302, BYK-306, BYK-307, BYK-310, BYK-320, BYK-322, BYK-323, BYK-325, BYK-330, BYK-331, BYK-333, BYK-335, BYK-341v344, BYK-345v346, BYK-348, BYK-354, BYK355, BYK-356, BYK-358, BYK-361, BYK-370, BYK-371, BYK-375, BYK-380, BYK-390, BYK-3550 (manufactured by BYK Chemie), and the like may be used. As the fluorine-based surfactant, F-114, F-177, F-410, F-411, F-450, F-493, F-494, F-443, F-444, F-445, F-446, F-470, F-471, F-472SF, F-474, F-475, F-477, F-478, F-479, F-480SF, F-482, F-483, F-484, F-486, F-487, F-172D, MCF-350SF, TF-1025SF, TF-1117SF, TF-1026SF, TF-1128, TF-1127, TF1129, TF-1126, TF-1130, TF-1116SF, TF-1131, TF1132, TF1027SF, TF-1441, TF-1442 (manufactured by DaiNippon Ink & Chemicals), and the like may be used.

If the hologram recording medium of one embodiment includes a surfactant, the surfactant may be contained in an amount of 0.01 parts by weight or more, 0.02 parts by weight or more, 0.03 parts by weight or more, or 0.05 parts by weight or more, and 5 parts by weight or less, or 3 parts by weight or less, based on 100 parts by weight of the polymer matrix. When the above range is satisfied, it can impart excellent adhesion and release properties to the photopolymer layer, and thus preserve excellent optical recording characteristics.

The hologram recording medium of one embodiment may include a silicone-based reactive additive as an antifoaming agent. As the silicone-based reactive additive, for example, commercially available products such as Tego Rad 2500 can be used. The content of the antifoaming agent can be appropriately adjusted at a level that does not impede the function of the hologram recording medium.

The photopolymer layer may be formed from a photopolymer composition including a solvent.

The solvent may be an organic solvent, and an example thereof may be at least one organic solvent selected from the group consisting of ketones, alcohols, acetates, and ethers, but is not limited thereto. Specific examples of such organic solvents include at least one selected from the group consisting of ketones such as methyl ethyl ketone, methyl isobutyl ketone, acetylacetone, or isobutyl ketone; alcohols such as methanol, ethanol, n-propanol, i-propanol, n-butanol, i-butanol, or t-butanol; acetates such as ethyl acetate, i-propyl acetate, or polyethylene glycol monomethyl ether acetate; and ethers such as tetrahydrofuran or propylene glycol monomethyl ether.

The organic solvent may be added at the time point when respective components contained in the photopolymer composition are mixed, or may be included in the photopolymer composition while respective components are added in a state of being dispersed or mixed in an organic solvent.

The photopolymer composition may include a solvent such that the solid content concentration is 1 to 90% by weight. Specifically, the photopolymer composition may include a solvent such that the solid concentration is 20% by weight or more, or 30% by weight or more, and 85% by weight or less, 80% by weight or less, 75% by weight or less, or 70% by weight or less. Within this range, the photopolymer composition exhibits appropriate flowability and can form a coating layer without defects such as stripes. No defects occur during the drying and curing process and thus, a photopolymer layer

exhibiting desired physical properties and surface properties can be formed.

The hologram recording medium of one embodiment may further include a substrate on at least one surface of the photopolymer layer. The type of the substrate is not particularly limited, and those known in the related technical field may be used. For example, substrates such as glass, PET (polyethylene terephthalate), TAC (triacetyl cellulose), PC (polycarbonate), or COP (cycloolefin polymer) may be used.

The hologram recording medium of one embodiment can achieve excellent refractive index modulation and high diffraction efficiency despite having a thin thickness.

The thickness of the photopolymer layer may be, for example, in the range of 5.0 to 40.0 μm. Specifically, the lower limit of the thickness of the photopolymer layer may be, for example, 6 μm or more, 7 μm or more, 8 μm or more, or 9 μm or more. And, the upper limit of the thickness may be, for example, 35 μm or less, 30 μm or less, 29 μm or less, 28 μm or less, 27 μm or less, 26 μm or less, 25 μm or less, 24 μm or less, 23 μm or less, 22 μm or less, 21 μm or less, 20 μm or less, 19 μm or less, or 18 μm or less.

The hologram recording medium of one embodiment can realize a refractive index modulation value ($\Delta n$) of 0.020 or more, 0.025 or more, 0.026 or more, 0.027 or more, 0.028 or more, 0.029 or more, 0.030 or more, 0.031 or more, 0.032 or more, 0.033 or more, 0.034 or more, or 0.035 or more even if the thickness of the photopolymer layer is as thin as 5 to 30 μm. The upper limit of the refractive index modulation value is not particularly limited, but may be, for example, 0.060 or less.

The hologram recording medium of one embodiment is not limited thereto, but may be a medium on which a reflective hologram or a transmissive hologram is recorded.

The hologram recording medium may have a notch filter structure in relation to the diffraction grating structure. The hologram recording medium of one embodiment having a notch filter structure may mean that the diffraction grating is non-slanted (substantially 0°) with respect to the substrate surface, for example, as if the diffraction grating is parallel to the substrate surface. Such a hologram recording medium may have a structure in which two layers having different refractive indexes (e.g., a high refractive index layer and a low refractive index layer) are alternately repeated. Further, the two repeated layers may respectively have a predetermined thickness that is the same or different from each other. Such a non-slanted diffraction grating record can be prepared in such a way that the incident angles of the incident object light and reference light are made equal based on the normal line. In the non-slanted structure, the degree of deformation (e.g., shrinkage or expansion) under high temperature and high humidity conditions is further clearly confirmed compared to the slanted structure, and it is less affected by the shrinkage and expansion of the substrate.

The hologram recording medium of one embodiment can record optical information in all of the red (R), green (G), and blue (B) regions (hereinafter, referred to as "RGB region"). If all optical information of the RGB region is recorded, a full-color hologram image can be reproduced.

However, it is not limited thereto, and optical information may be recorded by irradiating light from one or two regions selected from the red (R), green (G), and blue (B) regions depending on the intended application of the hologram recording medium. By way of non-limiting example, since the hologram recording medium of one embodiment has high visibility, it can be utilized for reproducing holographic images such as letters, etc. In this case, optical information may be recorded by irradiating light from only one region selected from the red (R), green (G), and blue (B) regions.

The hologram recording medium of one embodiment exhibits high diffraction efficiency. Specifically, when a notch filter hologram is recorded by irradiating the photopolymer layer with light from only one region selected from the red, green, or blue region, the diffraction efficiency ($DE_{S_\lambda}$) measured at the corresponding recording wavelength may be 80% or more. The diffraction efficiency ($DE_{S_\lambda}$) may correspond to $DE^0$ in Equations 1 and 2.

More specifically, $DE^0$ in Equations 1 and 2 may be, for example, 80% or more, 85% or more, 86% or more, 87% or more, 88% or more, 89% or more, 90% or more, 91% or more, 92% or more, 93% or more, 94% or more, 95% or more, or 96% or more, and the upper limit thereof is not particularly limited but may be, for example, 100% or less.

In Equations 1 and 2, $DE^0$ may be the diffraction efficiency for the red region ($DE_{S_RED}{}^0$), the diffraction efficiency for the green region ($DE_{S_GREEN}{}^0$), or the diffraction efficiency for the blue region ($DE_{S_BLUE}{}^0$). The hologram recording medium of one embodiment may exhibit excellent diffraction efficiency in all of the red, green, and blue regions. The diffraction efficiency for the red region ($DE_{S_RED}{}^0$), the diffraction efficiency for the green region ($DE_{S_GREEN}{}^0$), and the diffraction efficiency for the blue region ($DE_{S_BLUE}{}^0$) may all fall within the above range. Specifically, the diffraction efficiency for the red region ($DE_{S-RED}{}^0$) may be, for example, 80% or more, 85% or more, 86% or more, 87% or more, 88% or more, 89% or more, or 90% or more. The diffraction efficiency for the green region ($DE_{S_GREEN}{}^0$) may be, for example, 80% or more, 85% or more, 86% or more, 87% or more, 88% or more, 89% or more, 90% or more, 91% or more, 92% or more, 93% or more, 94% or more, 95% or more, or 96% or more. The diffraction efficiency for the blue region ($DE_{S_BLUE}{}^0$) may be, for example, 80% or more, 85% or more, 86% or more, 87% or more, 88% or more, 89% or more, 90% or more, 91% or more, or 92% or more.

The hologram recording medium of one embodiment exhibits excellent room temperature long-term storage stability and thus maintain excellent optical recording properties even after being left for a long time. Specifically, the hologram recording medium of one embodiment may maintain excellent optical recording properties for all of the red,

green, and blue regions, even after being left for a long time at room temperature.

In one example, room temperature DE retention rates of the red region, the green region, and the blue region calculated by the following Equation 1 may be 95% or more, 96% or more, 97% or more, 98% or more, or 99% or more.

The hologram recording medium of one embodiment also exhibits excellent thermal stability and thus maintain excellent optical recording properties even when exposed to high temperature. Specifically, the hologram recording medium of one embodiment may maintain excellent optical recording properties in all of the red, green, and blue regions after being left at high temperature.

In one example, high temperature DE retention rates of the red region, the green region, and the blue region calculated by the following Equation 2 may be 86% or more, 87% or more, 88% or more, 89% or more, 90% or more, 91% or more, 92% or more, 93% or more, 94% or more, 95% or more, 96% or more, or 97% or more.

The measurement methods for room temperature DE retention rate and high temperature DE retention rate may refer to the methods described in Test example described below. The upper limits of the room temperature DE retention rate and high temperature DE retention rate are not particularly limited but may be, for example, 100% or less. Due to measurement errors or equipment deviation, the diffraction efficiency measured after room temperature or high temperature storage may be higher than the diffraction efficiency before storage. In this case, the DE retention rate is considered to be 100%.

The use of the hologram recording medium of one embodiment is not particularly limited. By way of non-limiting example, the hologram recording medium may be used in applications likely to be exposed to high temperatures, specifically, smart devices such as mobile devices, parts of wearable displays, vehicle articles (e.g., head up display) and the like.

On the other hand, according to another embodiment of the disclosure, there is provided a method for preparing a hologram recording medium, comprising a step of applying a photopolymer composition to form a photopolymer layer, wherein the photopolymer composition includes a polymer matrix or a precursor thereof, a photoreactive monomer and a photoinitiator system, wherein the photoinitiator system includes a photosensitizing dye and a co-initiator, wherein the photosensitizing dye includes a photosensitizing dye for the red region, a photosensitizing dye for the green region, and a photosensitizing dye for the blue region, wherein room temperature DE retention rates of the red region, the green region, and the blue region calculated by Equation 1 are 95% or more, and wherein high temperature DE retention rates of the red region, the green region, and the blue region calculated by Equation 2 are 86% or more.

The photopolymer composition may be the photopolymer composition for forming the photopolymer layer in the hologram recording medium of one embodiment. Since its components have been described in detail previously, a detailed description will be omitted here.

In the step of forming the photopolymer layer, a photopolymer composition containing the above-mentioned configuration may first be prepared. When preparing the photopolymer composition, for mixing each component, a commonly known blender, stirrer, mixer or the like may be used without particular restriction. Further, such a mixing process may be performed at a temperature ranging from 0°C to 100°C, a temperature ranging from 10°C to 80°C, or a temperature ranging from 20°C to 60°C.

In the step of forming the photopolymer layer, the prepared photopolymer composition may be applied to form a coating layer formed from the photopolymer composition. The coating layer may be dried naturally at room temperature or dried at a temperature of 30°C to 80°C. Through this process, a hydrosilylation reaction between the hydroxyl group of the acrylic-based polyol remaining unreacted and the silane functional group of the siloxane-based polymer may be induced.

In the photopolymer layer prepared through the step of forming the photopolymer layer, a photoreactive monomer, a photosensitizing dye, a co-initiator, and additives added as necessary may be uniformly dispersed within the crosslinked polymer matrix.

The method for preparing the hologram recording medium according to another embodiment may further include a step of recording optical information by irradiating a coherent laser onto a predetermined region of the photopolymer layer and selectively polymerizing the photoreactive monomer contained in the photopolymer layer after the step of forming the photopolymer layer.

In the step of recording optical information, if a coherent laser is irradiated onto the photopolymer layer, polymerization of photoreactive monomers occurs to form a photopolymer in the constructive interference region, and polymerization of photoreactive monomer does not occur or is suppressed in the destructive interference region, so that the photoreactive monomer are present. Further, while the unreacted photoreactive monomer causes refractive index modulation while diffusion occurs toward the photopolymer side where the concentration of photoreactive monomers is lower, and a diffraction grating is produced by the refractive index modulation. Thereby, holograms, i.e. optical information, are recorded on the photopolymer layer having the diffraction grating.

The method for preparing the hologram recording medium according to another embodiment may further include a step of photobleaching by irradiating light onto the entire photopolymer layer on which the optical information is recorded after the step of recording the optical information.

In the photobleaching step, ultraviolet rays are irradiated onto the photopolymer layer on which optical

information is recorded to terminate the reaction of the photoreactive monomer remaining in the photopolymer layer and remove the color of the photosensitizing dye. In one example, in the photobleaching step, ultraviolet rays (UVA) in the range of 320 to 400 nm are irradiated to terminate the reaction of the photoreactive monomer and remove the color of the photosensitizing dye.

On the other hand, according to yet another embodiment of the disclosure, there is provided an optical element comprising the hologram recording medium.

Specific examples of the optical elements may include smart devices such as mobile devices, parts of wearable displays, vehicle articles (e.g., head up display), holographic fingerprint recognition system, optical lenses, mirrors, deflecting mirrors, filters, diffusing screens, diffraction elements, light guides, waveguides, holographic optical elements having projection screen and/or mask functions, medium of optical memory system and light diffusion plate, optical wavelength multiplexers, reflection type, transmission type color filters, and the like.

An example of an optical element including the hologram recoding medium may include a hologram display device. The hologram display device includes a light source unit, an input unit, an optical system, and a display unit.

Specifically, the light source unit is a portion that irradiates a laser beam used for providing, recording, and reproducing three-dimensional image information of an object in the input unit and the display unit.

The input unit is a portion that previously inputs three-dimensional image information of an object to be recorded on the display unit, specifically, a portion in which three-dimensional information of an object such as the intensity and phase of light for each space may be inputted into an electrically addressed liquid crystal SLM, wherein an input beam may be used.

The optical system may include a mirror, a polarizer, a beam splitter, a beam shutter, a lens, and the like. The optical system may be distributed into an input beam for sending a laser beam emitted from the light source unit to the input unit, a recording beam for sending the laser beam to the display unit, a reference beam, an erasing beam, a reading beam, and the like.

The display unit may receive three-dimensional image information of an object from an input unit, record it on a hologram plate comprising an optically addressed SLM, and reproduce the three-dimensional image of the object. At this time, the three-dimensional image information of the object may be recorded via interference of the input beam and the reference beam. The three-dimensional image information of the object recorded on the hologram plate may be reproduced into a three-dimensional image by the diffraction pattern generated by the reading beam. The erasing beam may be used to quickly remove the formed diffraction pattern. On the other hand, the hologram plate may be moved between a position at which a three-dimensional image is inputted and a position at which a three-dimensional image is reproduced.

## [ADVANTAGEOUS EFFECTS]

According to one embodiment of the disclosure, the hologram recording medium is capable of recording full-color optical information, has excellent diffraction efficiency in the red, green, and blue regions, and has excellent stability at room temperature and high temperature, so that it can exhibit excellent reliability even when left at room temperature for a long time or exposed to high temperature.

## [BRIEF DESCRIPTION OF THE DRAWINGS]

FIG. 1 schematically shows the recording equipment setup for hologram recording. Specifically, FIG. 1 schematically shows the process in which a laser of a predetermined wavelength is radiated from the light source 10, and irradiated onto the PP (hologram recording medium) 80 located on one surface of a mirror 70 via mirrors 20 and 20', an iris 30, a spatial filter 40, an iris 30', a collimation lens 50, and PBS (Polarized Beam Splitter) 60.

## [DETAILED DESCRIPTION OF THE EMBODIMENTS]

Hereinafter, the action and effect of the invention will be described in more detail with reference to specific examples of the invention. However, these examples are presented for illustrative purposes only, and the scope of the invention is not limited thereby in any way.

In the following Preparation Examples, Examples, Comparative Examples, and the like, the content of raw materials, and the like means the content based on solid content, unless otherwise specified.

### Preparation Example 1: Preparation of acrylic-based polyol

132 g of butyl acrylate, 420 g of ethyl acrylate, and 48 g of hydroxybutyl acrylate were added to a 2 L jacketed reactor, and diluted with 1200 g of ethyl acetate. The reaction temperature was set to 60~70°C, and the mixture was stirred

for about 30 minutes to 1 hour. 0.42 g of n-dodecyl mercaptan (n-DDM) was further added, and stirring was further performed for about 30 minutes. Then, 0.24 g of AIBN as a polymerization initiator was added, polymerization was performed at the reaction temperature for 4 hours or more, and kept until the residual acrylate content became less than 1%. Thereby, an acrylate-based copolymer (weight average molecular weight of about 300,000, OH equivalent of about 1802 g/equivalent) in which the hydroxy group was located in the branched chain was prepared.

**Preparation Example 2: Preparation of fluorinated compound**

20.51 g of 2,2'-{oxybis[(1,1,2,2-tetrafluoroethane-2,1-diyl)oxy]}bis(2,2-difluoroethan-1-ol) was added to a 1000 mL flask, and dissolved in 500 g of tetrahydrofuran, to which 4.40 g of sodium hydride (60% dispersion in mineral oil) was carefully added several times while stirring at 0°C. After stirring at 0°C for 20 minutes, 12.50 mL of 2-methoxyethoxymethyl chloride was slowly added dropwise. When it was confirmed by 1H NMR that all the reactants were consumed, work-up using dichloromethane gave 29 g of a liquid product with a purity of 95% or more in a yield of 98%. The weight average molecular weight of the prepared fluorinated compound was 586, and the refractive index measured with an Abbe refractometer was 1.361.

**Example 1: Preparation of photopolymer composition and hologram recording medium**

(1) Preparation of photopolymer composition

First, 0.57 g of poly(methylhydrosiloxane) (Sigma-Aldrich, number average molecular weight: about 590, Si-H equivalent: about 103 g/equivalent) as a siloxane-based polymer and 33.4 g of the acrylic-based polyol (solid content: 10.02 g) prepared in Preparation Example 1 (solid content: 30 wt%) were mixed (SiH/OH molar ratio = 1.0).

Then, 0.11 g of a compound (Blue) represented by the following Chemical Formula A-1, 0.11 g of a compound (Red) represented by the following Chemical Formula B, and 0.10 g of rhodamine 6G (Green) were added as a photosensitizing dye; 13.5 g of a fluorinated compound prepared in Preparation Example 2 was added as a plasticizer; 0.10 g of Tego Rad 2500 was added as a silicone-based reactive additive; and methyl isobutyl ketone and methyl ethyl ketone were added as a solvent, and the mixture was stirred with a paste mixer for about 10 minutes while blocking light. After that, Karstedt (Pt-based) catalyst was added for matrix crosslinking.

Subsequently, 16.9 g of HR 6042 (Miwon Specialty Chemical, refractive index of 1.60) as a photoreactive monomer, 1.0 g of borate V as an electron donor (co-initiators), and 0.53 g of Irgacure 819 as a photoinitiator were added into the mixture, and stirred for at least 5 minutes to prepare a photopolymer composition.

[Chemical Formula A-1]

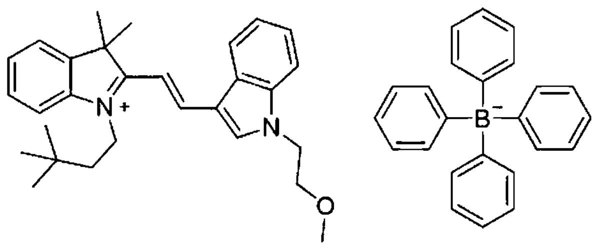

[Chemical Formula B]

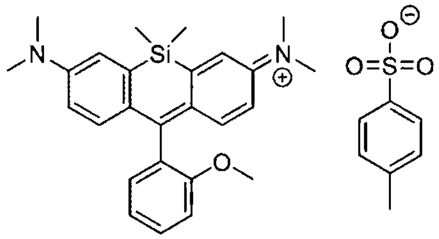

(2) Preparation of hologram recording medium

The photopolymer composition was coated to a predetermined thickness on a 60 μm thick TAC substrate using a Mayer bar, and dried at 60°C for 30 minutes. The thickness of the photopolymer layer after drying was about 15 μm.

**<u>Example 2 and Comparative Examples 1 to 6: Preparation of photopolymer composition and hologram recording medium</u>**

A photopolymer composition and a hologram recording medium were prepared in the same manner as in Example 1, except that the photosensitizing dye was changed as shown in Table 1 below.

**[Table 1]**

| | Photosensitizing dye | | |
|---|---|---|---|
| | Blue | Red | Green |
| Example 1 | [Chemical Formula A-1]<br>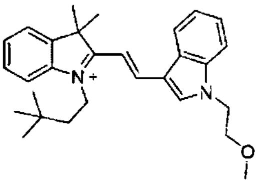 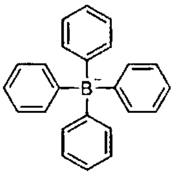 | [Chemical Formula B]<br>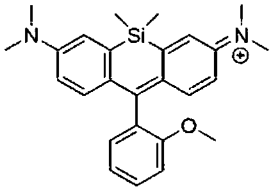 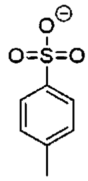 | Rhodamine 6G |
| Example 2 | [Chemical Formula A-2]<br>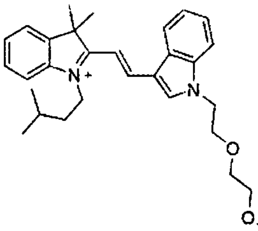 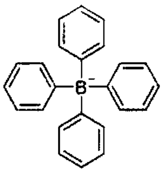 | [Chemical Formula B]<br>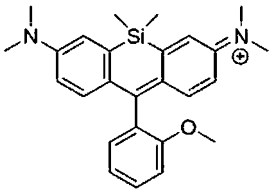 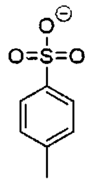 | Rhodamine<br>6G |
| Comparative Example 1 | [Chemical Formula A-1]<br>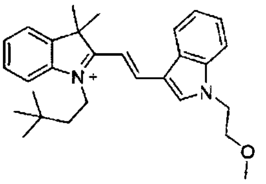 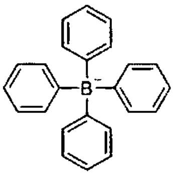 | Hnu-640 | Rhodamine 6G |
| Comparative Example 2 | [Chemical Formula A-1]<br>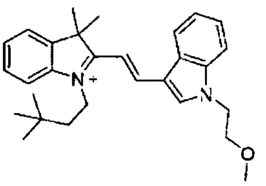 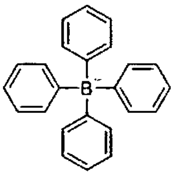 | [Chemical Formula B]<br>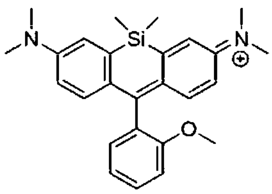 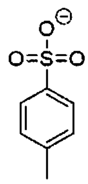 | Rhodamine B |

(continued)

| | Photosensitizing dye | | |
|---|---|---|---|
| | Blue | Red | Green |
| Comparative Example 3 | [Chemical Formula A-1] 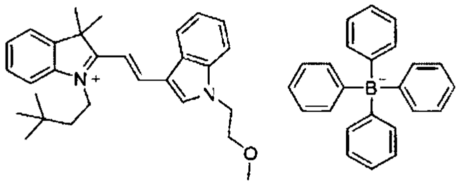 | [Chemical Formula B] 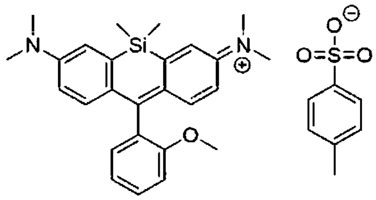 | Safranin O |
| Comparative Example 4 | Hnu-470 | [Chemical Formula B] 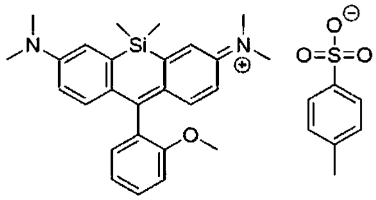 | Rhodamine 6G |
| Comparative Example 5 | Acridine Orange | [Chemical Formula B] 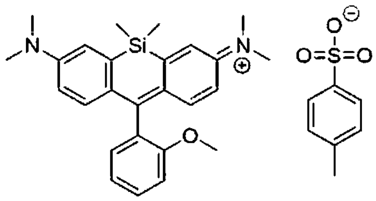 | Rhodamine 6G |
| Comparative Example 6 | Bis-Coumarin | [Chemical Formula B] 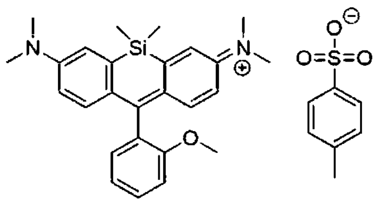 | Rhodamine 6G |

Test Example: Performance evaluation of hologram recording medium

(1) Diffraction efficiency (DE)

a) Single Recording

A diffraction grating was recorded using the same setup as shown in FIG. 1. Specifically, when the prepared photopolymer layer was laminated on a mirror and then irradiated with a laser, a notch filter hologram with periodic refractive index modulation in the thickness direction could be recorded through interference between incident light (L) and light reflected from the mirror (L').

A laser with only one wavelength selected from 640 nm (red), 532 nm (green), and 460 nm (blue) was irradiated for optical information recording. At that time, the incident angle was 0° (degree), the laser intensity was 1.5 mW/cm$^2$, and the exposure time was 30 seconds to record a notch filter hologram. Notch filter and Bragg reflector are optical devices that reflect only light of a specific wavelength, and have a structure in which two layers with different refractive indices are stacked periodically and repeatedly at a constant thickness.

b) Measurement of Diffraction Efficiency (Initial diffraction efficiency, $DE^0$, %)

Diffraction efficiency was determined through the following Equation 3 for the sample after recording. $DE_{S-RED}{}^0$, $DE_{S_GREEN}{}^0$, and $DE_{S_BLUE}{}^0$ were obtained as initial diffraction efficiencies $DE^0$, respectively.

[Equation 3]

$$DE_{X_\lambda}(\%) = \{(T_0 - T_m) / T_0\} \times 100$$

in Equation 3,

X is denoted as F when lights from the red, green, and blue regions are irradiated simultaneously, and as S when light from only one of the red, green, or blue regions is irradiated,
$\lambda$ represents the recording wavelength region, which is one of the red (RED), green (GREEN), or blue (BLUE) regions,
$DE_{X_\lambda}$ is a diffraction efficiency in the recording wavelength range of the sample recorded according to the X method,
$T_0$ is a transmittance measured in the recording wavelength region for a sample that has been photobleached in a state where no optical information is recorded, and $T_m$ is a transmittance in the recording wavelength region for a sample that has been photobleached in a state where optical information is recorded.

(2) Diffraction Efficiency Retention Rate (DE Retention Rate, %)

The room temperature storage stability and high temperature stability of the hologram recording medium were confirmed through the degree of diffraction efficiency maintenance after being stored at room temperature or high temperature.

a) Room temperature DE retention rate (%)

Samples before recording were stored at room temperature (about 25 $\pm$ 5°C) for 180 days, and then three samples were prepared by recording the optical information of the red, green, or blue region for each sample. The optical information was recorded according to above a) Single Recording method in (1) Diffraction efficiency (DE). The diffraction efficiency ($DE^{RT}$) was measured through Equation 3 for the sample after recording. $DE_{S_RED}{}^{RT}$, $DE_{S_GREEN}{}^{RT}$, and $DE_{S_BLUE}{}^{RT}$ were obtained as the diffraction efficiencies measured after storage at room temperature $DE^{RT}$, respectively.

The diffraction efficiency (DE) retention rate after storage at room temperature was calculated by the following Equation 1. $DE^{RT}$ at the corresponding recording wavelength was substituted according to $DE^0$. That is, when $DE_{S_RED}{}^0$ was substituted for $DE^0$, $DE_{S_RED}{}^{RT}$ was substituted for $DE^{RT}$.

[Equation 1]

$$\text{room temperature DE retention rate } (\%) = 100 \times DE^{RT} / DE^0$$

in Equation 1,

$DE^0$ is a diffraction efficiency of the red region, the green region, or the blue region measured after recording a Notch filter hologram by irradiating light in the red region, the green region, or the blue region onto the hologram recording medium, and
$DE^{RT}$ is a diffraction efficiency of the red region, the green region, or the blue region measured after recording a Notch filter hologram by irradiating light in the red region, the green region, or the blue region onto the hologram recording medium which is stored at 20 to 30°C for 180 days in an unrecorded state.

b) High temperature DE retention rate (%)

Samples before recording were stored at 60°C for 30 days, and then three samples were prepared by recording the optical information of the red, green, or blue region for each sample. The optical information was recorded according to above a) Single Recording method in (1) Diffraction efficiency (DE). The diffraction efficiency ($DE^{HT}$) was measured through Equation 3 for the sample after recording. $DE_{S_RED}{}^{HT}$, $DE_{S_GREEN}{}^{HT}$, and $DE_{S_BLUE}{}^{HT}$ were obtained as the diffraction efficiencies measured after storage at high temperature $DE^{HT}$, respectively.

The diffraction efficiency (DE) retention rate after storage at high temperature was calculated by the following

Equation 2. $DE^{HT}$ at the corresponding recording wavelength was substituted according to $DE^0$. That is, when $DE_{S_RED}^0$ was substituted for $DE^0$, $DE_{S_RED}^{HT}$ was substituted for $DE^{HT}$.

[Equation 2]

$$\text{high temperature DE retention rate (\%)} = 100 \times DE^{HT} / DE^0$$

in Equation 2,

$DE^0$ is a diffraction efficiency of the red region, the green region, or the blue region measured after recording a Notch filter hologram by irradiating light in the red region, the green region, or the blue region onto the hologram recording medium, and

$DE^{HT}$ is a diffraction efficiency of the red region, the green region, or the blue region measured after recording a Notch filter hologram by irradiating light in the red region, the green region, or the blue region onto the hologram recording medium which is stored at 60°C for 30 days in an unrecorded state.

[Table 2]

| | Initial diffraction efficiency | | | Room temperature DE retention rate | | | High temperature DE retention rate | | |
|---|---|---|---|---|---|---|---|---|---|
| | $DE_{S_RED}^0$ (%) | $DE_{S_GREEN}^0$ (%) | $DE_{S_BLUE}^0$ (%) | Red (%) | Green (%) | Blue (%) | Red (%) | Green (%) | Blue(%) |
| Example 1 | 90.2 | 94.5 | 91.8 | 99.8 | 100.0 | 99.9 | 99.8 | 99.9 | 98.3 |
| Example 2 | 88.8 | 96.2 | 92.5 | 99.1 | 100.0 | 100.0 | 100.0 | 100.0 | 97.9 |
| Comparative Example 1 | 75.2 | 92.5 | 90.9 | 78.5 | 100.0 | 99.7 | 32.2 | 99.3 | 94.8 |
| Comparative Example 2 | 93.5 | 68.2 | 92.1 | 99.7 | 99.9 | 100.0 | 100.0 | 85.3 | 95.6 |
| Comparative Example 3 | 92.3 | 79.3 | 93.2 | 100.0 | 89.7 | 99.8 | 99.3 | 44.8 | 97.8 |
| Comparative Example 4 | 90.7 | 91.9 | 12.3 | 100.0 | 100.0 | 95.6 | 100.0 | 100.0 | 23.1 |
| Comparative Example 5 | 91.2 | 94.7 | 33.1 | 99.9 | 100.0 | 90.3 | 100.0 | 99.2 | 31.2 |
| Comparative Example 6 | 89.3 | 93.2 | 67.6 | 100.0 | 99.8 | 88.7 | 99.1 | 100.0 | 55.9 |

Referring to Table 2, it was confirmed that Examples 1 and 2 exhibited high diffraction efficiency in all of the red, green, and blue regions, and that the diffraction efficiency in all regions was maintained at an excellent level even when left at room temperature or high temperature for a long time.

In contrast, Comparative Example 1 showed poor diffraction efficiency in the red region, Comparative Examples 2 and 3 showed poor diffraction efficiency in the green region, and Comparative Examples 4 to 6 showed poor diffraction efficiency in the blue region. In addition, Comparative Examples 1 to 6 showed poor stability at room temperature or high temperature.

Accordingly, it is confirmed that the hologram recording medium according to one embodiment of the disclosure is capable of recording full-color optical information, has excellent diffraction efficiency in the red, green, and blue regions, and exhibits excellent stability at room temperature and high temperature.

## Claims

1. A hologram recording medium comprising: a photopolymer layer which includes a polymer matrix or a precursor

thereof; and a photoreactive monomer and a photoinitiator system or a photopolymer obtained therefrom;

wherein the photoinitiator system includes a photosensitizing dye and a co-initiator,
wherein the photosensitizing dye includes a photosensitizing dye for the red region, a photosensitizing dye for the green region, and a photosensitizing dye for the blue region,
wherein room temperature DE retention rates of the red region, the green region, and the blue region calculated by the following Equation 1 are 95% or more, and
wherein high temperature DE retention rates of the red region, the green region, and the blue region calculated by the following Equation 2 are 86% or more:

[Equation 1]

$$\text{room temperature DE retention rate (\%)} = 100 \times DE^{RT} / DE^{0}$$

[Equation 2]

$$\text{high temperature DE retention rate (\%)} = 100 \times DE^{HT} / DE^{0}$$

in Equations 1 and 2,
$DE^0$ is a diffraction efficiency of the red region, the green region, or the blue region measured after recording a Notch filter hologram by irradiating light in the red region, the green region, or the blue region onto the hologram recording medium,
$DE^{RT}$ is a diffraction efficiency of the red region, the green region, or the blue region measured after recording a Notch filter hologram by irradiating light in the red region, the green region, or the blue region onto the hologram recording medium which is stored at 20 to 30°C for 180 days in an unrecorded state, and
$DE^{HT}$ is a diffraction efficiency of the red region, the green region, or the blue region measured after recording a Notch filter hologram by irradiating light in the red region, the green region, or the blue region onto the hologram recording medium which is stored at 60°C for 30 days in an unrecorded state.

**2.** The hologram recording medium according to claim 1, wherein the polymer matrix is formed by crosslinking a siloxane-based polymer containing a silane functional group and an acrylic-based polyol.

**3.** The hologram recording medium according to claim 2, wherein the siloxane-based polymer comprises a repeating unit represented by the following Chemical Formula 1 and a terminal end group represented by the following Chemical Formula 2:

[Chemical Formula 1]

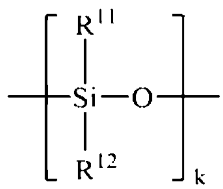

in Chemical Formula 1,

a plurality of $R^{11}$ and $R^{12}$ are the same or different from each other, and are each independently hydrogen, halogen, or an alkyl group having 1 to 10 carbon atoms, and
k is an integer of 1 to 10,000,

[Chemical Formula 2]

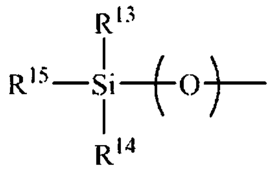

in Chemical Formula 2,
a plurality of $R^{13}$ to $R^{15}$ are the same or different from each other, and are each independently hydrogen, halogen, or an alkyl group having 1 to 10 carbon atoms, and
at least one of $R^{11}$ to $R^{15}$ of at least one repeating unit selected among the repeating units represented by Chemical Formula 1 and any one terminal end group selected among the terminal end groups represented by Chemical Formula 2 is hydrogen.

**4.** The hologram recording medium according to claim 2, wherein the acrylic-based polyol is a polymer in which a hydroxy group is bonded to the main chain or side chain of an acrylate-based polymer.

**5.** The hologram recording medium according to claim 1, wherein the photoreactive monomer comprises at least one monofunctional monomer selected from the group consisting of benzyl (meth)acrylate, benzyl 2-phenylacrylate, phenoxybenzyl (meth)acrylate, phenol (ethylene oxide) (meth)acrylate, phenol (ethylene oxide)$_2$ (meth)acrylate, O-phenylphenol (ethylene oxide) (meth)acrylate, phenylthioethyl (meth)acrylate and biphenylmethyl (meth)acrylate; at least one polyfunctional monomer selected from the group consisting of bisphenol A (ethylene oxide)$_{2\sim10}$ di(meth) acrylate, bisphenol A epoxy di(meth)acrylate, bisfluorene di(meth)acrylate, modified bisphenol fluorene di(meth) acrylate, tris(2-hydroxyethyl)isocyanurate tri(meth)acrylate, phenol novolac epoxy (meth)acrylate and cresol novolac epoxy (meth)acrylate; or a mixture of two or more thereof.

**6.** The hologram recording medium according to claim 1, wherein the photosensitizing dye for the blue region comprises a cation-containing compound represented by the following Chemical Formula 3:

[Chemical Formula 3]

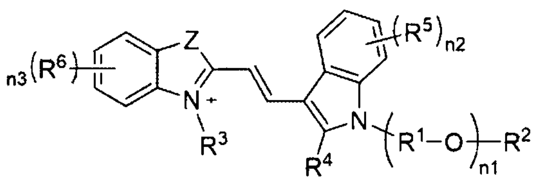

in Chemical Formula 3,

$R^1$ is an alkylene group having 1 to 6 carbon atoms, $R^2$ is an alkyl group having 1 to 6 carbon atoms,
n1 is an integer of 1 to 6,
$R^3$ is an alkyl group having 3 to 12 carbon atoms,
$R^4$ is hydrogen or an alkyl group having 1 to 6 carbon atoms,
$R^5$ and $R^6$ are each independently a halogen, a hydroxyl group, an alkyl group having 1 to 6 carbon atoms, or an alkoxy group having 1 to 6 carbon atoms,
n2 and n3 are each independently an integer of 0 to 4,
Z is oxygen, sulfur, or $CR^7R^8$,
$R^7$ and $R^8$ are each independently an alkyl group having 1 to 6 carbon atoms.

**7.** The hologram recording medium according to claim 6, wherein the cation-containing compound represented by Chemical Formula 3 comprises a tetraaryl borate as an anion.

**8.** The hologram recording medium according to claim 7, wherein the tetraaryl borate comprises at least one anion selected from the group consisting of tetra(phenyl) borate, tetrakis(fluorophenyl) borate, tetrakis(chlorophenyl) borate, tetrakis(methylphenyl) borate, tetrakis(methoxyphenyl) borate, tetrakis(fluoromethylphenyl) borate, tetrakis(fluoromethoxyphenyl) borate, tetrakis(chloromethylphenyl) borate, and tetrakis(chloromethoxyphenyl) borate.

**9.** The hologram recording medium according to claim 1, wherein the photosensitizing dye for the red region comprises a silicon rhodamine compound represented by the following Chemical Formula 4:

[Chemical Formula 4]

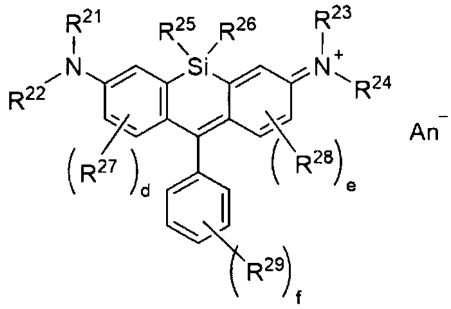

in Chemical Formula 4,

$R^{21}$ to $R^{29}$ are each independently hydrogen, a substituted or unsubstituted alkyl group having 1 to 20 carbon atoms, a substituted or unsubstituted alkoxy group having 1 to 20 carbon atoms, a substituted or unsubstituted aryl group having 6 to 30 carbon atoms, or a substituted or unsubstituted aryloxy group having 6 to 30 carbon atoms,
d and e are each independently an integer of 0 to 3,
f is an integer of 0 to 5, and
$An^-$ is an anion.

**10.** The hologram recording medium according to claim 1, wherein the photosensitizing dye for the green region comprises at least one compound selected from the group consisting of a compound represented by the following Chemical Formula 5, a compound represented by the following Chemical Formula 6, thioerythrosine triethylammonium and erythrosin B:

[Chemical Formula 5]

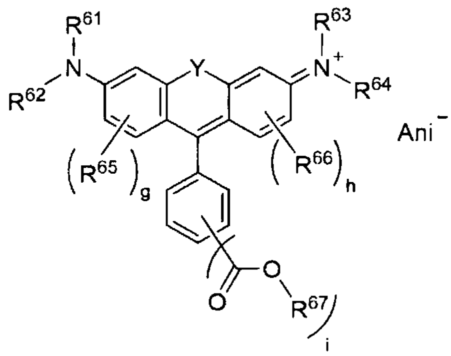

in Chemical Formula 5,

Y is O or S,
$R^{61}$ to $R^{66}$ are each independently hydrogen or a substituted or unsubstituted alkyl group having 1 to 20 carbon atoms,
$R^{67}$ is a substituted or unsubstituted alkyl group having 1 to 20 carbon atoms,
g and h are each independently an integer of 0 to 3,
i is an integer of 0 to 5,
$Ani^-$ is an anion,

[Chemical Formula 6]

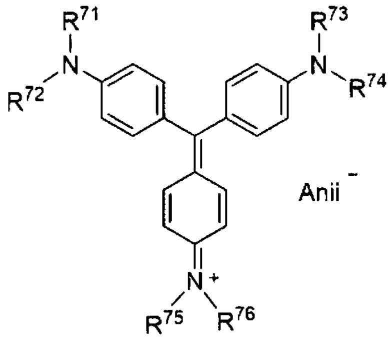

in Chemical Formula 6,
$R^{71}$ to $R^{77}$ are each independently a substituted or unsubstituted alkyl group having 1 to 20 carbon atoms, and
$Anii^-$ is an anion.

**11.** The hologram recording medium according to claim 1, wherein a diffraction efficiency for the red region ($DE_{S_RED}{}^0$), a diffraction efficiency for the green region ($DE_{S_GREEN}{}^0$), and a diffraction efficiency for the blue region ($DE_{S_BLUE}{}^0$) are all 80% or more as $DE^0$ in Equation 1.

**12.** A method for preparing a hologram recording medium, comprising a step of applying a photopolymer composition to form a photopolymer layer,

wherein the photopolymer composition comprises a polymer matrix or a precursor thereof, a photoreactive monomer and a photoinitiator system,
wherein the photoinitiator system includes a photosensitizing dye and a co-initiator,
wherein the photosensitizing dye includes a photosensitizing dye for the red region, a photosensitizing dye for the green region, and a photosensitizing dye for the blue region,
wherein room temperature DE retention rates of the red region, the green region, and the blue region calculated by the following Equation 1 are 95% or more, and
wherein high temperature DE retention rates of the red region, the green region, and the blue region calculated by the following Equation 2 are 86% or more:

[Equation 1]

$$\text{room temperature DE retention rate (\%)} = 100 \times DE^{RT} / DE^0$$

[Equation 2]

$$\text{high temperature DE retention rate (\%)} = 100 \times DE^{HT} / DE^0$$

in Equations 1 and 2,
$DE^0$ is a diffraction efficiency of the red region, the green region, or the blue region measured after recording a Notch filter hologram by irradiating light in the red region, the green region, or the blue region onto the hologram recording medium,
$DE^{RT}$ is a diffraction efficiency of the red region, the green region, or the blue region measured after recording a Notch filter hologram by irradiating light in the red region, the green region, or the blue region onto the hologram recording medium which is stored at 20 to 30°C for 180 days in an unrecorded state, and
$DE^{HT}$ is a diffraction efficiency of the red region, the green region, or the blue region measured after recording a Notch filter hologram by irradiating light in the red region, the green region, or the blue region onto the hologram recording medium which is stored at 60°C for 30 days in an unrecorded state.

**13.** The method according to claim 12, further comprising a step of recording optical information by irradiating a coherent laser onto a predetermined region of the photopolymer layer and selectively polymerizing the photoreactive monomer

contained in the photopolymer layer.

**14.** An optical element comprising the hologram recording medium according to claim 1.

【FIG. 1】

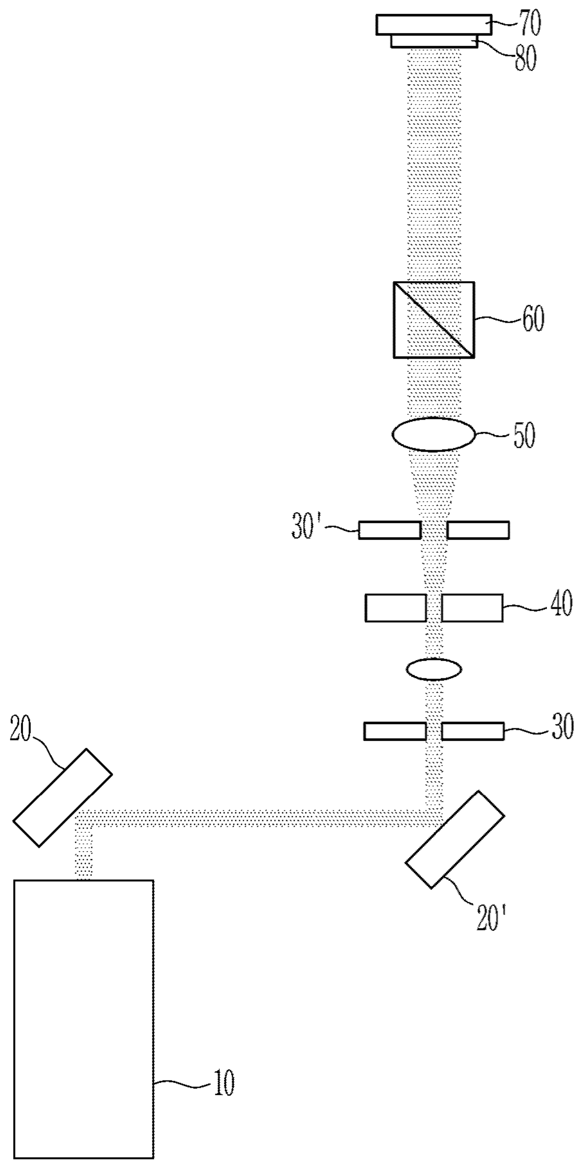

**INTERNATIONAL SEARCH REPORT**

International application No.
**PCT/KR2025/002237**

**A. CLASSIFICATION OF SUBJECT MATTER**

**G03F 7/105**(2006.01)i; **C08F 287/00**(2006.01)i; **C08F 2/44**(2006.01)i; **C08F 2/50**(2006.01)i; **C08G 77/42**(2006.01)i; **C08G 77/38**(2006.01)i; **C08G 77/12**(2006.01)i; **C08K 5/3417**(2006.01)i; **C08K 5/55**(2006.01)i; **C08K 5/549**(2006.01)i

According to International Patent Classification (IPC) or to both national classification and IPC

**B. FIELDS SEARCHED**

Minimum documentation searched (classification system followed by classification symbols)

G03F 7/105(2006.01); C08F 2/44(2006.01); C08F 2/50(2006.01); C08F 275/00(2006.01); C08F 283/12(2006.01); C08L 33/10(2006.01); C09B 11/00(2006.01); G03F 7/004(2006.01); G03F 7/032(2006.01); G03F 7/075(2006.01); G11B 7/24(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal), STN (registry, caplus), google & keywords: 홀로그램 매체(holographic medium), 고분자 매트릭스(polymer matrix), 광반응성 단량체(photoreactive monomer), 광개시제(photoinitiator), 광중합체(photopolymer), 광감응 염료(photosensitive dye), 회절 효율(diffraction efficiency), 광학 소자(optical element)

**C. DOCUMENTS CONSIDERED TO BE RELEVANT**

| Category* | Citation of document, with indication, where appropriate, of the relevant passages | Relevant to claim No. |
|---|---|---|
| A | KR 10-2021-0003510 A (LG CHEM, LTD.) 12 January 2021 (2021-01-12)<br>See claims 1-16; paragraphs [0067] and [0086]-[0088]; and example 1. | 1-14 |
| A | KR 10-2023-0083786 A (LG CHEM, LTD.) 12 June 2023 (2023-06-12)<br>See claims 1-20; and paragraphs [0164]-[0165]. | 1-14 |
| A | KR 10-2176588 B1 (SAMSUNG ELECTRONICS CO., LTD.) 09 November 2020 (2020-11-09)<br>See claims 1-18; paragraph [0006]; and table 1. | 1-14 |
| A | KR 10-2022-0112996 A (LG CHEM, LTD.) 12 August 2022 (2022-08-12)<br>See claims 1-15; and paragraphs [0150]-[0153]. | 1-14 |
| A | KR 10-2005-0027566 A (CHOI, Dong Hoon) 21 March 2005 (2005-03-21)<br>See entire document. | 1-14 |

☑ Further documents are listed in the continuation of Box C. ☑ See patent family annex.

* Special categories of cited documents:
"A" document defining the general state of the art which is not considered to be of particular relevance
"D" document cited by the applicant in the international application
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **15 May 2025** | **16 May 2025** |

| Name and mailing address of the ISA/KR | Authorized officer |
|---|---|
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

INTERNATIONAL SEARCH REPORT

International application No.
PCT/KR2025/002237

C. DOCUMENTS CONSIDERED TO BE RELEVANT

| Category* | Citation of document, with indication, where appropriate, of the relevant passages | Relevant to claim No. |
|---|---|---|
| A | KR 10-2013-0126611 A (BAYER INTELLECTUAL PROPERTY GMBH) 20 November 2013 (2013-11-20)<br>See entire document. | 1-14 |

Form PCT/ISA/210 (second sheet) (July 2022)

**INTERNATIONAL SEARCH REPORT**
**Information on patent family members**

International application No.
**PCT/KR2025/002237**

| Patent document cited in search report | Publication date (day/month/year) | Patent family member(s) | Publication date (day/month/year) |
|---|---|---|---|
| KR 10-2021-0003510 A | 12 January 2021 | CN 112639617 A | 09 April 2021 |
| | | CN 112639617 B | 23 August 2024 |
| | | EP 3838937 A1 | 23 June 2021 |
| | | EP 3838937 A4 | 27 October 2021 |
| | | EP 3838937 B1 | 14 September 2022 |
| | | JP 2021-536039 A | 23 December 2021 |
| | | JP 7130306 B2 | 05 September 2022 |
| | | KR 10-2384288 B1 | 06 April 2022 |
| | | US 11851515 B2 | 26 December 2023 |
| | | US 2021-0340302 A1 | 04 November 2021 |
| | | WO 2021-002648 A1 | 07 January 2021 |
| KR 10-2023-0083786 A | 12 June 2023 | None | |
| KR 10-2176588 B1 | 09 November 2020 | KR 10-2014-0059695 A | 16 May 2014 |
| | | RU 2012147529 A | 20 September 2014 |
| | | RU 2552351 C2 | 10 June 2015 |
| | | US 2014-0127611 A1 | 08 May 2014 |
| | | US 9128460 B2 | 08 September 2015 |
| KR 10-2022-0112996 A | 12 August 2022 | EP 4120018 A1 | 18 January 2023 |
| | | EP 4120018 A4 | 13 September 2023 |
| | | US 2023-0142827 A1 | 11 May 2023 |
| | | WO 2022-169307 A1 | 11 August 2022 |
| KR 10-2005-0027566 A | 21 March 2005 | None | |
| KR 10-2013-0126611 A | 20 November 2013 | CN 103222000 A | 24 July 2013 |
| | | CN 103222000 B | 10 August 2016 |
| | | EP 2450893 A1 | 09 May 2012 |
| | | EP 2638544 A2 | 18 September 2013 |
| | | EP 2638544 B1 | 26 December 2018 |
| | | ES 2717635 T3 | 24 June 2019 |
| | | JP 2013-543149 A | 28 November 2013 |
| | | JP 6144625 B2 | 07 June 2017 |
| | | KR 10-1804608 B1 | 04 December 2017 |
| | | PL 2638544 T3 | 31 July 2019 |
| | | TR 201904304 T4 | 21 May 2019 |
| | | TW 201237119 A | 16 September 2012 |
| | | TW 201631052 A | 01 September 2016 |
| | | TW I593761 B | 01 August 2017 |
| | | TW I612105 B | 21 January 2018 |
| | | US 2013-0224634 A1 | 29 August 2013 |
| | | US 2016-0054704 A1 | 25 February 2016 |
| | | US 9146456 B2 | 29 September 2015 |
| | | US 9760060 B2 | 12 September 2017 |
| | | WO 2012-062655 A2 | 18 May 2012 |
| | | WO 2012-062655 A3 | 07 September 2012 |

Form PCT/ISA/210 (patent family annex) (July 2022)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- KR 1020240022510